(19) Europäisches Patentamt

European Patent Office

Office européen des brevets

(11) **EP 1 861 759 B1**

(12) **EUROPEAN PATENT SPECIFICATION**

(45) Date of publication and mention
of the grant of the patent:
**03.12.2008 Bulletin 2008/49**

(51) Int Cl.:
***G05D 23/00*** (2006.01)     ***G05B 11/00*** (2006.01)
***G01R 31/28*** (2006.01)

(21) Application number: **06736186.5**

(22) Date of filing: **27.02.2006**

(86) International application number:
**PCT/US2006/006810**

(87) International publication number:
**WO 2006/096361 (14.09.2006 Gazette 2006/37)**

(54) **APPARATUS AND METHOD FOR CONTROLLING TEMPERATURE IN A CHUCK SYSTEM**

VORRICHTUNG UND VERFAHREN ZUM REGELN DER TEMPERATUR IN EINEM EINSPANNSYSTEM

APPAREIL ET PROCEDE DESTINES A REGULER LA TEMPERATURE DANS UN SYSTEME DE MANDRIN

(84) Designated Contracting States:
**AT BE BG CH CY CZ DE DK EE ES FI FR GB GR HU IE IS IT LI LT LU LV MC NL PL PT RO SE SI SK TR**

(30) Priority: **04.03.2005 US 658452 P**
**08.04.2005 US 669685 P**

(43) Date of publication of application:
**05.12.2007 Bulletin 2007/49**

(73) Proprietor: **Temptronic Corporation**
**Sharon, MA 02067-1653 (US)**

(72) Inventors:
• **ELSDOERFER, Norbert, W.**
**Warwick, Rhole Island 02886 (US)**

• **MIKULINA, Olga, V.**
**Wayland, Massachusetts 01788 (US)**
• **MOURCHID, Abdellah**
**East Boston, Massachusetts 02128 (US)**

(74) Representative: **Gambell, Derek et al**
**Graham Watt & Co LLP**
**St Botolph's House**
**7-9 St Botolph's Road**
**Sevenoaks**
**Kent TN13 3AJ (GB)**

(56) References cited:
**US-A- 3 710 251**     **US-A- 4 056 708**
**US-A- 5 205 132**     **US-A1- 2002 003 037**
**US-A1- 2003 155 939**     **US-B1- 6 549 026**
**US-B2- 6 700 099**

**EP 1 861 759 B1**

## Description

Background of the Invention

Integrated circuits are subjected to a series of test and evaluation steps to ensure the highest quality. This is particularly important to the semiconductor industry, where it is important to screen defective wafers before more expensive packaging steps are applied. One important test step is to temperature-screen the wafer. A thermal chuck is used to provide precision temperature control during the temperature-screening process. In a typical configuration, the thermal chuck holds the wafer in a stationary position while the wafer is subjected to extreme temperature variations over predetermined periods of time. For example, it is desired that the wafer be exposed to a high temperature and abruptly exposed to an extremely low temperature. Therefore, it is important that the thermal chuck be configured to support a temperature transition from a high thermal chuck temperature to a low thermal chuck temperature, also referred to as a set point temperature, or vice-versa, from a low thermal chuck temperature to a high thermal chuck temperature, in the shortest amount of time possible.

Typical conventional thermal chuck systems control such temperature transitions by applying a fixed gain via an amplifier to a chuck heater (for increasing the chuck temperature) or to a coolant circulation system (for decreasing the chuck temperature). However, the fixed gain approach is not feasible when abruptly transitioning from a very high temperature, for example, a temperature above 200°C, to a desired lower temperature, for example, around 25°C. While conventional thermal chuck systems can include a coolant circulation system to decrease the chuck temperature, a severe undershoot, i.e., a drop below the set point temperature, can occur due the sudden decrease in temperature, particularly from high temperature, thereby hindering temeprature control accuracy and increasing the time required to reach steady state at the desired set point temperature.

United States patent US 3710251 (Hagge et al.) describes a microelectric wafer or chip vacuum chuck in the form of a heat exchanger pedestal with a heat exchanger pressure vessel at the pedestal top through which hot and cold fluids are selectively pumped in circulation from and return to, respectively, hot and cold remote fluid reservoirs. A plurality of small diameter vacuum tubes pierce the heat exchanger pressure vessel and are brazed at each end to upper and lower plates with the top of the upper plate being the chuck surface with the vacuum tubes providing frequent tension ties between the plates. Dry nitrogen is fed into and through a circumferential passageway about the pedestal to protect wafers and chips with an inert cover atmosphere from oxidation damage at high temperatures or frost damage at low temperature.

United States patent US 4056708 (Soodak et al.) describes a temperature control assembly for a centrifugal chemical treatment apparatus of the type having a temperature monitoring thermistor and a rotor heater. The heater is energized from a power source through a solid state relay. The thermistor is connected in a temperature Wheatstone bridge which delivers a voltage signal to a digital voltmeter. The digital voltmeter generates a binary output which is compared in a computer with a digital command signal from a keyboard unit. The binary computer output is a programmed function of the difference between the keyboard digital temperature command signal and the voltmeter output. This computer output controls a variable duty cycle multivibrator stage which provides a relay-operating signal whose "on" time is in accordance with the difference between the keyboard command temperature and the digital voltmeter output signal. This operating signal is delivered to the relay via an over-temperature and failure detector receiving signals from the digital voltmeter. The relay is held open if forbidden signals are received, such as signals of incorrect polarity, over-range signals, signals resulting from a meter defect, signals resulting from a shorted or open thermistor, or the like. The same reference voltage is used for the digital voltmeter and the temperature Wheatstone bridge so that changes in reference voltage do not affect the voltmeter readings. The bridge is designed so that the bridge output in volts is equal to 1/100 of the temperature in degrees Centigrade to facilitate display, over the specified design temperature range. The voltmeter is of a type providing forbidden signal outputs, including over-range, wrong polarity, overload, etc.

An embodiment of United States patent US 5205132 (Fu) is a temperature forcing system and method for precision temperature control of a device-under-test. The system comprises a thermal test head suspended by a support arm that receives a temperature controlled air flow through an output hose from an air supply system. A pair of temperature sensors, one attached to the device-under-test and the other in the output hose, are used differentially by a closed-loop temperature controller when the temperature of the device-under-test comes within a temperature window surrounding a target temperature setpoint point. Outside the temperature window control is linear and within the temperature window control is compensated by a correction factor obtained during a single calibration test that amalgamates the effects of the mass of the device-under-test, the ambient conditions and other factors.

Summary of the Invention

To address the above limitations, a feature of the present invention is to provide a temperature control system and method for controlling temperature in a thermal chuck which provides increased temperature control accuracy and improved efficiency, and reduces undershoot during a temperature cooling operation.

In accordance with an aspect of the invention, there is provided a temperature controller that manages a temperature transition in a thermal chuck from either a high temperature to a low temperature, or from a low temperature to a high temperature. In addition, the temperature controller can perform heating and cooling operations concurrently to achieve the desired result of minimizing undershoot.

The temperature controller manages a temperature transitions by using time proportional control. Specifically, the temperature controller comprises a time proportional controller. The time proportional controller includes a gain scheduler and a duty cycle scheduler to determine optimal proportions of air and fluid to be alternately output to the thermal chuck during a predefined period. The proportion of times during which fluid, e.g. water, and air are provided to the chuck during the predefined period or time interval is the fluid duty cycle for the time interval. The gain scheduler generates a proportion band and a transition gain at the beginning of a temperature transition by determining the difference between the actual temperature of the chuck at the beginning of the temperature transition, referred to as a measured temperature, and a desired temperature, also referred to as a set point temperature. The time proportional controller controls a set of air and fluid valves according to a duty cycle calculated from the proportion band and the transition gain.

As the temperature decreases during the temperature transition, the deviation between the measured temperature and desired temperature, and thus the duty cycle, will also decrease. The time proportional controller will control the air and fluid valves such that appropriate proportions of air and fluid are provided to the chuck in each predefined period. When the measured temperature is within a small predefined temperature range, referred to as the dead-band temperature range, the gain scheduler will cease to calculate a duty cycle, and a different set of calculations, and secondary control actions, will be performed in order to achieve the desired effect of minimizing undershoot.

A feature of the present invention is that the time proportional controller can provide appropriate proportions of air and fluid during the temperature transition, and perform a controlled cooling operation and heating operation to ensure that undershoot is minimized.

Another feature of the present invention is that the time proportional controller forms a plurality of control regions from the chuck temperature range. Each control region has an associated control approach which may include a gain scheduler that calculates a proportion band at the beginning of a temperature transition that is specific to the control region. In this manner, the present invention addresses certain inherent temperature behavior that occurs in the various control regions.

In accordance with an aspect of the invention, there is provided a temperature control system for a chuck comprising a first input for receiving air from an air source, a second input for receiving a fluid from a fluid source, and at least one output for alternately transferring the air and fluid in proportions to the chuck to control a surface temperature of the chuck.

The fluid can comprise water and can be temperature-controlled.

In an embodiment, the temperature control system further comprises a first temperature control system for controlling an increase of the surface temperature and a second temperature control system for controlling a decrease of the surface temperature. The surface temperature decrease is controlled by alternating the air and fluid in the proportions during a predefined period. The second temperature control system includes low-temperature processes and controller processes for managing temperature transitions among a plurality of control regions.

In accordance with another aspect of the invention, there is provided a thermal chuck system comprising a first input, a second input, at least one output, a first temperature control system, and a second temperature control system. The first input receives air from an air source. The second input receives a temperature-controlled fluid from a fluid source. The at least one output alternately transfers the air and fluid in proportions to a thermal chuck. The first temperature control system controls an increase of a surface temperature. The second temperature control system controls a decrease of the surface temperature by alternating the air and fluid in the proportions during the predefined period. The second temperature control system includes low-temperature processes and controller processes for managing temperature transitions among a plurality of control regions. The fluid can comprise water.

In an embodiment, the thermal chuck is a 200mm chuck. In another embodiment, the thermal chuck is a 300mm thermal chuck.

In an embodiment, the thermal chuck system further comprises a valve control box and a time proportional controller. The valve control box comprises an air valve for outputting the air and a fluid valve for outputting the temperature-controlled fluid. The fluid valve can be at least one of a high flow solenoid valve and a low flow solenoid valve. The air valve and the fluid valve outputs the air and fluid in an alternating mode in response to the controller. The valve control box can further include a base air valve for providing a base cooling.

In an embodiment, the time proportional controller comprises an interface, a control region processor, a controller process, and a low-temperature process. The interface receives measured temperature information from the thermal chuck. The control region processor defines the plurality of control regions and a plurality of low-temperature regions. The controller process is in each control region. The low-temperature process is in each low-temperature region.

The control region processor can define each control region and low-temperature region by temperature boundaries. In this manner, when a first temperature is in a first control region of the plurality of control regions, a first controller process of the first control region adjusts the air and fluid proportions, and when the first temperature is transitioned to a second temperature in a second control region, a second controller process of the second control region adjusts the air and fluid proportions. The first control region and the second control region can be the same. Alternatively, the first control region and the second control region can be different control regions in the plurality of control regions.

In an embodiment, a dead-band region in the second control region provides an approximate temperature region for the second temperature, and the second controller process controls the dead-band region to reduce an undershoot during the transition from the first temperature to the second temperature. The second controller process can reduce the undershoot by alternating the first input of air and the second input of fluid in proportions. Alternatively, the second controller process can reduce the undershoot by disabling the first input of air and the second input of fluid. Temperature sensors can provide chuck temperature measurements to the thermal chuck system.

In an embodiment, each controller process comprises a gain scheduler that computes a proportion band during the predefined period. The proportion band can determine the proportions of air and fluid input to the chuck during the predefined period. The proportion band can be calculated in response to the chuck temperature measurements.

A suitable time proportional controller for controlling a thermal chuck comprises an interface, a control region processor, a controller process, and a low-temperature process. The interface receives a measured chuck surface temperature from the thermal chuck. The control region processor defines a plurality of control regions and low temperature regions. The controller process is in each control region, and controls a transition between temperatures of the control regions and low temperature regions, and a low-temperature process for each low-temperature region.

In an embodiment, the controller process of each control region comprises a gain scheduler for computing a proportion band in each of the plurality of control regions. The proportion band can determine a proportion of air and fluid inputs to the thermal chuck during a predefined period. The controller process of each control region further comprises a dead-band mode for determining a dead-band temperature range in each control region, and for reducing an undershoot formed during the temperature transition. Each control region and low temperature region can be separated by temperature boundaries. The controller can minimize an undershoot by disabling the proportion of air and fluid inputs during the predefined period when a measured temperature in the dead-band temperature range.

In another embodiment, the controller controls a heater for transitioning the measured temperature to a desired temperature when the measured temperature is lower than the desired temperature.

In an embodiment, the controller controls a plurality of valves for transitioning the measured temperature to a desired temperature when the measured temperature is higher than the desired temperature.

In a suitable method for controlling a chuck temperature air is received from an air source, and fluid is received from a fluid source. The air and fluid is alternately transferred in proportions to the chuck. A temperature of the fluid can be controlled.

In an embodiment, an increase of a surface temperature of the chuck is controlled, and a decrease of the surface temperature is controlled by alternating the air and fluid in the proportions during a predefined period. Temperature transitions can be managed among a plurality of control regions.

In accordance with another aspect of the invention, there is provided a method for controlling a temperature of a chuck comprising. In the method, air is received from an air source, and a temperature-controlled fluid is received from a fluid source. Air and fluid is alternately transferred in proportions to the chuck. An increase of the chuck temperature is controlled. A decrease of the chuck temperature is controlled by alternating the air and fluid in the proportions during a predefined period. Temperature transitions among a plurality of control regions are managed. The air and fluid can be outputted in an alternating mode in response to a time proportional controller.

Measured temperature information can be received from the chuck.

The plurality of control regions and low-temperature regions can be defined by temperature boundaries.

In an embodiment, air and fluid proportions in a first control region of the plurality of control regions is adjusted when a first temperature is in the first control region, wherein when the first temperature is transitioned to a second temperature in a second control region, air and fluid proportions in the second control region are adjusted.

The first control region and the second control region can be the same. Alternatively, the first control region and the second control region can be different control regions in the plurality of control regions.

In an embodiment, an approximate temperature region is provided as a dead-band region in the second control region for the second temperature, and the dead-band region is controlled to reduce an undershoot during the transition from the first temperature to the second temperature. The undershoot can be reduced by alternating the first input of air and the second input of fluid in proportions. Alternatively, the undershoot can be reduced by disabling the first input of air and the second input of fluid.

A proportion band can be computed during the predefined period, the proportion band determining the proportions of air and fluid input to the chuck during the predefined period, the proportion band being calculated in response to the chuck temperature measurements.

In accordance with another aspect of the invention, there is provided a method for controlling a chuck temperature. In the method, a measured chuck surface temperature is received from a thermal chuck. A plurality of control regions is defined, each control region having a controller process, and low temperature regions, each low temperature region having a low-temperature process. A transition between temperatures of the control regions and low-temperature regions is controlled. The transition between temperatures can be controlled by computing a proportion band in each control region, the proportion band determining a proportion of air and fluid inputs to the thermal chuck during a predefined period, and determining a dead-band temperature range in each control region, and reducing an undershoot formed during the temperature transition. Each control region and low temperature region can be separated by temperature boundaries. An undershoot can be minimized by disabling the proportion of air and fluid inputs during the predefined period when a measured temperature is in the dead-band temperature range.

In an embodiment, a heater is controlled for transitioning the measured temperature to a desired temperature when the measured temperature is lower than the desired temperature.

In an embodiment, a plurality of valves is controlled for transitioning the measured temperature to the desired temperature when the measured temperature is higher than the desired temperature.

Brief Description of the Drawings

The foregoing and other objects, features and advantages of the invention will be apparent from the more particular description of preferred aspects of the invention, as illustrated in the accompanying drawings in which like reference characters refer to the same parts throughout the different views. The drawings are not necessarily to scale, emphasis instead being placed upon illustrating the principles of the invention.

FIG. 1 contains a schematic block diagram of a thermal chuck system according to an embodiment the present invention.

FIG. 2 contains a schematic block diagram of the valve control box shown in FIG. 1 according to an embodiment of the present invention.

FIG. 3 contains a schematic block diagram of a temperature controller shown in FIG. 1 according to an embodiment of the present invention.

FIG. 4 contains a graph illustrating the temperature controller shown in FIG. 3 performing a series of control actions comprising alternating air and fluid in a predefined period according to the present invention.

FIG. 5 contains a graph of undershoot at various temperatures in a thermal chuck without the gain scheduling of the present invention.

FIG. 6 contains a graph illustrating temperature undershoot in response to a gain scheduler, duty cycle scheduler, and dead-band mode according to the present invention.

FIG. 7A contains a graph illustrating undershoot resulting from multiple temperature transitions during a cooling operation in a thermal chuck without the temperature control approach of the invention.

FIG. 7B contains a graph illustrating undershoots resulting from multiple temperature transitions during a cooling operation using the temperature control approach according to the present invention.

FIG. 8 contains a state diagram illustrating temperature transition results occurring in a plurality of control regions according to the present invention.

Detailed Description of Preferred Embodiments of the Invention

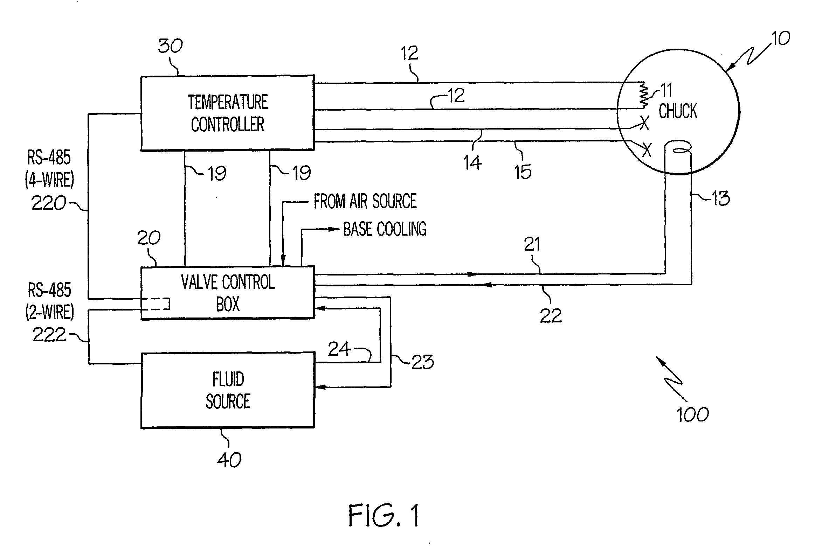

FIG. 1 contains a schematic block diagram of a thermal chuck system 100 using the temperature control approach according to an embodiment of the present invention. The thermal chuck system 100 includes a thermal chuck 10, a valve control box 20, a temperature controller 30, and a fluid source 40. The fluid source 40 may be an off-the-shelf water chiller, for example, a Neslab M-75™ water chiller. The chuck 10 many be mounted on a host machine, such as a wafer prober machine, which provides electrical test signals to circuits formed in the wafer and detects the circuits' responses to these test stimulus signals. Because the chuck 10 controls temperature of the wafer, this circuit prober testing can be performed over temperature to characterize performance of the circuits and/or the wafer over temperature.

The present invention is directed to and is applicable to temperature-controlled or thermal semiconductor wafer chucks of the type described in, for example, U.S. Patent No. 6,700,099, issued March 2, 2004, entitled "Wafer Chuck Having Thermal Plate With Interleaved Heating and Cooling Elements, Interchangeable Top Surface Assemblies and Hard Coated Layer Surfaces," assigned to Temptronic Corporation, and incorporated herein in its entirety by reference. The thermal chuck 10 holds a semiconductor wafer in place during processing and provides a controlled temperature to the wafer under test. The thermal chuck 10 can be, for example, a chuck for supporting semiconductor wafers such as 300mm wafers and 200mm wafers.

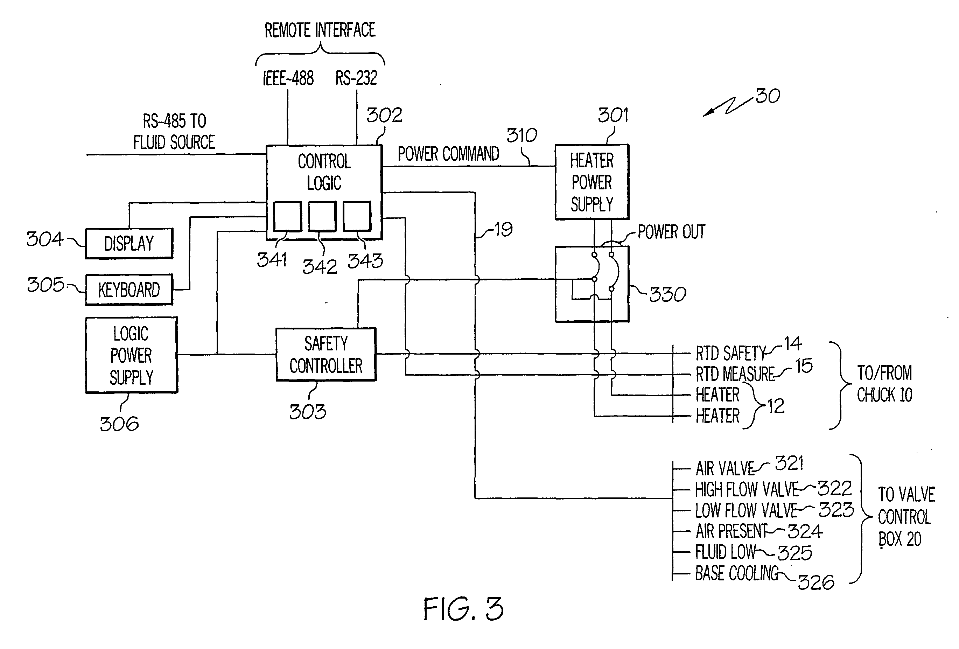

The thermal chuck 10 includes a heater 11 that includes one or more resistive heating elements to provide heat to the thermal chuck 10. The heating elements of the thermal chuck 10 are powered by a heater power supply 301 (FIG. 3) of the temperature controller 30 which provides power to the heating elements via conductors 12 between the temperature controller 30 and the thermal chuck 10.

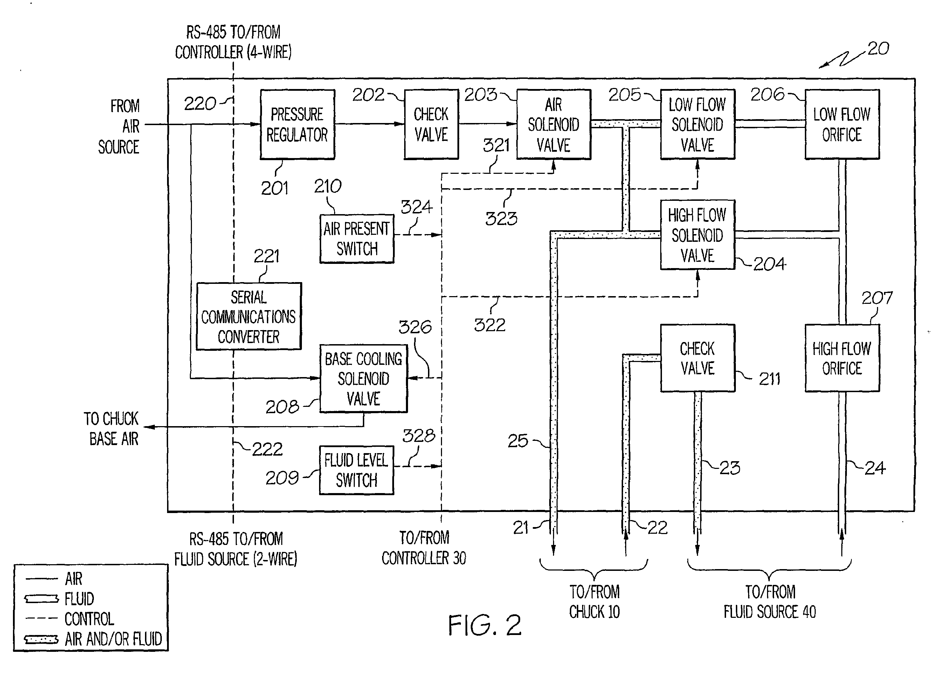

The thermal chuck 10 further includes a cooling element 13 that receives a temperature-controlled fluid such as water from the valve control box 20 via fluid lines 21 and 22 and circulates the fluid through the thermal chuck 10. As described below, a high flow solenoid valve 204 and a low flow solenoid valve 205 of the valve control box 20 (FIG. 2) control the flow of fluid to the thermal chuck 10. A fluid path 21, 22 connects the thermal chuck 10 to the valve control box 20, whereby the fluid can conduct heat to and from the thermal chuck 10 via the fluid path 21, 22 during the temperature control operation. When the fluid is removing heat from, i.e., cooling, the chuck 10, the valve control box 20 receives the heated fluid on line 22, and the heated fluid is returned to the fluid source 40 on line 23.

The temperature controlled fluid is received by the valve control box 20 from the fluid source or chiller 40 via line 24. The valve control box 20 routes the fluid at a controlled flow rate to the chuck 10 via line 21. The air/fluid path 21 connects the thermal chuck 10 to the valve control box 20, whereby air and fluid are provided to the thermal chuck 10 from the valve control box 20 via at least one air/fluid path 21 . The air and fluid are alternately transferred to the thermal chuck 10. During a predefined period, air is inputted to the thermal chuck 10 via the air/fluid path 21 for a proportion of the predefined period, and the fluid is inputted to the thermal chuck 10 via the air/fluid path 21 for the remaining proportion of the predefined period. The proportion of fluid to air provided to the chuck during the predefined period is calculated as part of the control approach of the invention to provide fast, accurate, and precisely controlled temperature transitions.

Temperature measurement sensors (not shown) located in the thermal chuck 10 collect measured temperature data at various locations in the thermal chuck 10, and provide temperature feedback by generating and forwarding an RTD measure signal to the temperature controller 30 via electrical signal line 15. Another signal line 14 is connected to an over-temperature safety processor in the temperature controller 30. When the chuck temperature exceeds the maximum permitted temperature of the thermal chuck 10, an over temperature sensor (not shown) in the thermal chuck 10 sends a signal to an over temperature safety controller 303 in the temperature controller 30 (FIG. 3). The over temperature safety controller 303 is connected to a safety relay 330 in the temperature controller 30, whereby a relay in the heater power supply lines is open to prevent a heater power supply 301 of the temperature controller 30 from applying further power to the heating elements 11. This feature is illustrated in detail in FIG. 3.

FIG. 2 is a schematic block diagram of the valve control box 20 according to an embodiment of the invention. The valve control box 20 includes inputs that receive air from an air source (FIG. 1), for example, a facility air source (not shown), and temperature-controlled fluid from the fluid source 40. The temperature-controlled fluid may be water or a cooling fluid or a combination of water and a cooling fluid. The temperature of the fluid is adjusted by the fluid source 40 based on control signals received from the temperature controller 30. When the fluid is output from the valve control box 20 to the thermal chuck 10, the fluid is circulated in the thermal chuck 10, whereby the circulated fluid carries heat away from or carries heat to the thermal chuck 10 via the fluid path 21, 22. In this manner, a wafer in the thermal chuck 10 may be exposed to very high temperatures by the heater 11, for example, up to 300° C for chucks supporting 300mm wafers, or up to 400° C for a chuck supporting 200mm wafers, and the wafer may be cooled to very low temperatures, for example, 5° C, by the circulating fluid.

The valve control box 20 includes a pressure regulator 201 for receiving air from the air source. The pressure regulator 201 can be, for example, a 20 psi regulator. The air can be received, for example, at 45 psi. The air is provided by the regulator 201 to a check valve 202, which in turn outputs the regulated air to an air solenoid valve 203.

The valve control box 20 comprises four solenoid valves that are used to route the fluid and the air through the thermal chuck system. These solenoid valves include the air solenoid valve 203, a high flow solenoid valve 204, a low flow solenoid valve 205, and a base cooling solenoid valve 208. The air solenoid valve 203 provides air to the chuck 10, and the high flow solenoid valve 204 and low flow solenoid valve 205 supply fluid to the chuck 10. The air check valve 202 receives air from the pressure regulator 201 and outputs the air to the air solenoid valve 203. The check valve 202 serves as a safety feature by preventing fluid from the high flow solenoid valve 204 or low flow solenoid valve 205 from reaching the pressure regulator 201. The air solenoid valve 203 includes a control input for receiving control signals from the temperature controller 30 to control opening and closing of the valve 203. In this manner, air from the air solenoid valve 203 is output to the thermal chuck 10 via an air/fluid path 25 of the valve control box 20, which in turn is supplied to the thermal chuck via the air/fluid path 21 of the thermal chuck.

The low flow solenoid 205 receives temperature-controlled fluid from a low flow orifice 206, which in turn receives the temperature-controlled fluid from a high flow orifice 207. In one embodiment, the low-flow orifice 206 controls the flow rate of the fluid to 150 ml/min, and the high flow orifice 207 controls the flow rate of the fluid to 600 ml/min. The high flow orifice 207 receives the temperature-controlled fluid from an outflow path 24 provided between the fluid source 40 and the high flow orifice 207 of the valve control box 20.

The high flow solenoid valve 204 can also receive the temperature-controlled fluid from the high flow orifice 207. In this manner, the high flow solenoid valve 204 or the low flow solenoid valve 205 may provide a high flow of fluid or a low flow of fluid to the thermal chuck 10, in response to the states of the solenoid control signals from the temperature controller 30, which are determined based on a set of conditions processed by the temperature controller 30. Details of the processing by the temperature controller 30 are described below.

The base cooling solenoid valve 208 enables and disables an air-cooling connection to base between the thermal chuck 10 and the host machine, e.g., wafer prober. In one embodiment, the temperature controller 30 enables the base cooling solenoid valve 208, whereby the base cooling solenoid valve 208 is in an "ON" state if the chuck temperature exceeds a temperature boundary of the thermal chuck temperature region, for example 60°C. The base cooling solenoid valve 208 applies air to the base under the thermal chuck 10 to prevent or reduce potentially damaging heat flow between the chuck and the host machine.

The valve control box 20 further comprises a fluid level switch 209. The fluid level switch 209 detects the level of the temperature control fluid and provides an indication when the fluid is below a threshold level to indicate that fluid must be added to fluid reservoirs. The fluid level switch 209 can also indicate the absence of fluid as an interlock to prevent system operation without fluid.

The valve control box 20 further comprises an air present switch 210. The air present switch 210 is used as a safety feature. For example, if pressurized air is present in the thermal chuck, the air present switch 210 is closed. If the air present switch 210 is open, the system enters a failure mode, whereby the air solenoid valve 203, high flow solenoid valve 204, and low flow solenoid valve 205 are in an "OFF" state, thereby preventing the valve control box 20 from operating. The air may be absent, for example, if the facility air source is not connected to the air input of the valve control box 20.

A check valve 211 receives fluid that has been circulated through the thermal chuck 10 and routes it back to the fluid source 40. The fluid is output from the thermal chuck 10 to the valve control box 20 via the fluid path 22. In particular, the check valve 211 receives the heated fluid via the fluid path 22 and outputs the fluid leaving the chuck 10, such that the fluid does not flow back to the chuck.

The temperature controller 30 communicates with the fluid source 40 using a serial communications protocol, for example the RS-485 protocol. The valve controller 20 includes a serial communications converter 221 that converts a 4-wire RS-485 connection 220 from the temperature controller 30 to a 2-wire RS-485 connection 222 to the fluid source 40.

FIG. 3 contains a schematic block diagram of the temperature controller 30 according to an embodiment the present invention.

The temperature controller 30 controls the temperature operations of the thermal chuck system, in particular the temperature heating and cooling operations of the thermal chuck. The temperature controller 30 comprises the heater power supply 301, control logic 302, over temperature safety controller 303, display 304, and keyboard 305.

The heater power supply 301 provides power to the chuck heater 11 of the thermal chuck 10 by generating power signals via conductors 12 required to operate the chuck heater 11. Each chuck heating element of the heater 11 may be driven by its own power signal received from the heater power supply 301. The heater power supply 301 is controlled by a power command signal received from the control logic 302 by way of an electrical connection 310 between the heater power supply 301 and the control logic 302.

The control logic 302 generates a plurality of control signals used to control the operation of the thermal chuck system 100. Control can be initiated by a remote operator via an IEEE-488 or RS-232 interface of the control logic, or by a local operator via the display 304 and keyboard 305 attached to the temperature controller 30.

The control logic comprises a first processor 341, second processor 342, and third processor 343. The first processor 341 performs control functions related to the user-interface operations, allowing users to manage the thermal chuck system from the display 304 and keyboard 305, or remotely via a remote interface, for example, the IEEE-488 or RS-232 interface. The second processor 342 generates control signals related to the heating operation performed by the heater 11 of the thermal chuck system. The third processor 343 generates control signals related to the temperature control operations of the thermal chuck system using the temperature-controlled fluid. The user-interface operation, temperature heating operation, and temperature cooling operation are described below. All three operations may be performed on the separate processors 341, 342, 343 or on a single processor.

As mentioned above, an operation executed by the second control processor 342 of control logic 302 generates the power command signal via a command signal line 310 and is used by the heater power supply 301 during a temperature transition from a low temperature to a high temperature, i.e., a chuck heating operation.

Referring to FIGs. 2 and 3, the control logic 302 generates a plurality of control signals via control signal lines 321, 322, 323, and 326, wherein the control signals are required to operate the valve control box 20. Specifically, the control logic 302 provides several control signals via connections to the valve control box 20 to control the relevant valves of the valve control box 20. In addition, the control logic 302 receives an air present signal via a control signal line 324 from the air present switch 210 of the valve control box. In addition, the control logic 302 receives a fluid low signal 325 indicating the fluid level is low. The control logic 302 also communicates with the fluid source 40 via the RS-485 interface. When a fluid low condition occurs, the air solenoid valve 203, low flow solenoid valve 205, and high flow solenoid valve 204 are commanded to an "OFF" state via control signal lines 321, 322, and 323.

Referring to FIGs. 2 and 3, an air valve control signal is generated by the control logic 302 and applied to the air solenoid valve 203 via control signal line 321 to control the air solenoid valve 203. For example, the air valve control signal can enable or disable the air solenoid valve 203. A high flow valve signal is generated by the control logic 302 and applied to the high flow solenoid valve via control signal line 322 to control the high flow solenoid valve 204. For example, the high flow valve control signal can enable or disable the high flow solenoid valve 204. A low flow valve signal is generated by the control logic 302 and applied to the low flow solenoid valve 205 via control signal line 323 to control the low flow solenoid valve 205. For example, the high flow valve control signal 323 can enable or disable the low flow solenoid valve 205. In addition, a base cooling valve signal is generated by the control logic 302 and applied to the base cooling solenoid valve 206 via control signal line 326 to control the base cooling solenoid valve 206.

The temperature controller 30 includes an over temperature safety controller 303 connected via a signal line 14 to an over-temperature sensor in the thermal chuck 10. When the chuck temperature exceeds the maximum permitted temperature of the thermal chuck 10, a sensor in the thermal chuck sends a Resistance Temperature Detector (RTD) safety signal via signal line 14 to the over temperature safety controller 303. The over temperature safety controller 303 is connected to a safety relay 330 in the temperature controller 30 to open the relay 330 to prevent the heater power supply 301 from applying further power to the heater 11.

The temperature controller 30 includes a logic power supply 306 that provides power to the control logic 302 and over temperature safety controller 303.

The temperature controller 30 further comprises a remote interface for receiving temperature parameters and system data from an external or remote user. The remote interface conforms to international I/O standards, for example, the RS-232 or IEEE-488 interface protocol. The remote interface can be connected to a remote terminal or personal computer by which a user can control the system.

Hence, a local operator can use the local display 304 and keyboard 305 to control the operation of the thermal chuck system, or a remote operator can remotely control the operation of the thermal chuck system. The control logic 302 presents a password-protected menu structure to either the display 304 or the remote console or computer that permits the operator to define required temperature parameters of the thermal chuck system. These parameters include, but are not limited to, relevant temperature ranges, chilled water temperature, a fixed gain coefficient, a low fluid timer, chuck purge time, and base purge temperatures. The above values can be configured through the local display 304 or from a remote console (not shown) attached to the IEEE-488 or RS-232 interface.

The operation of the temperature controller 30 of the invention will now be further described in detail. As described above, the control logic 302 of the temperature controller 30 receives electrical input signals from various system components of the thermal chuck system and transmits control signals to the system components as necessary to perform the required temperature control functions of the temperature controller 30. Specifically, the control logic 302 generates and forwards control signals to the valve control box 20 via conductors 19 such that appropriate combinations of air and temperature-controlled fluid can be applied to perform temperature control, including temperature transitions, in accordance with the invention. The fluid can be water or other aqueous fluid and may include an antifreeze to permit low-temperature operation. The temperature of the fluid is controlled by the fluid source 40 in conjunction with the temperature controller 30. The fluid flows through the thermal chuck system 100 at a high rate via the high flow solenoid valve 204 of the valve control box 20, or the fluid flows at a low rate via the low flow solenoid valve 205 of the valve control box 20. In this manner, the temperature control actions provided by the control logic 302 are optimized by controlling the temperature of the fluid circulating through the thermal chuck 10.

Temperature sensors located in the thermal chuck 10 collect measured temperature data at various locations in the thermal chuck, and provide temperature feedback to the control logic 302 of the temperature controller 30.

The temperature controller 30 uses time proportional control to perform a temperature cooling control function. Specifically, the control logic 302 uses a time proportional controller (not shown) to determine the optimal proportions of air and fluid to the thermal chuck 10 during each period of a temperature transition, and to control the flow of air and fluid to the thermal chuck 10 to enable and disable the air solenoid valve 203, high flow solenoid valve 204, and low flow solenoid valve 205 accordingly.

The time proportional controller includes a gain scheduler that computes a proportion band from a measured chuck temperature at the start of the temperature transition. The proportion band is determined by a fixed gain value, the initial measured temperature, and the chuck temperature range. The fixed gain value is based on certain behavior that the fluid may exhibit in the chuck at the temperature region of the initial measured temperature. For example, at temperatures above boiling point, when water is converted to steam, higher levels of heat may be removed from the chuck at a given point in time than at temperatures under the boiling point due to the larger amount of heat removed in the boiling of the water. The fixed gain constant in each case will therefore be different.

The gain scheduler also computes a fixed transition gain constant from the proportion band that is used to calculate a duty cycle for each period, or interval, in the temperature transition.

The duty cycle, also referred to as a modulated fluid, i.e., water, pulse width or control effort, is calculated by a duty cycle scheduler, which determines the difference between the measured chuck temperature and a desired temperature, or set point temperature, in each predefined period during the temperature transition. This difference is referred to as an error coefficient. The duty cycle is determined by multiplying the error coefficient and the transition gain in each predefined period.

When a temperature transition is initiated, the gain scheduler computes the proportion band and transition gain for the time proportional controller. The proportion band and transition gain are held constant throughout the temperature transition.

The error coefficient calculated in the first period of the temperature transition has the highest deviation. However, as the measured temperature is reduced in response to control actions of the temperature controller, the temperature decrease in each subsequent predefined period results in a decrease in the error coefficient. A new duty cycle is calculated from the error coefficient in each subsequent predefined period. The duty cycle is used by the temperature controller 30 to determine the appropriate proportions of air and fluid to be applied to the chuck 10 in each period. In response to the duty cycle, the time proportional controller controls the solenoid valves 203, 204, 205 such that appropriate proportions of air and fluid are alternately applied to the thermal chuck 10.

As mentioned above, a new duty cycle is calculated for each predefined period of the temperature transition. In one embodiment, the period or interval is generally configured at 4 seconds. During each 4-second interval, a duty cycle is calculated to determine the portion of time during the interval during which fluid is introduced into the chuck 10 from the value control box 20. Air is provided to the chuck 10 during the remaining portion of the 4-second interval. Hence, in general, fluid and air are alternately provided to the chuck 10 over the air/fluid path 21, 22, with the duty cycle being calculated by the control approach of the invention. Hence, the duty cycle is used by the time proportional controller to control the time proportion of water to air during each 4-second temperature control interval. Hence, the invention provides a pulse-width modulation approach to controlling the amount of fluid and air provided to the chuck.

It should be noted that, even though the proportion or duty cycle is calculated based on the difference between actual chuck temperature and desired temperature, the calculated fluid duty cycle or proportion may be 100%, resulting in a continuous, uninterrupted flow of fluid to the chuck. If the duty cycle is 100%, then in this example the air solenoid valve 203 remains closed such that no air is output to the chuck 10, and the high flow fluid valve 204 remains open to provide 100% fluid flow to the chuck 10 for the period. Specifically, in this control action, the high flow solenoid valve 204 is in an "ON" state for 100% of the predefined period. During the same period, the air solenoid valve 203 is in an "OFF" state. The measured temperature will therefore decrease.

It should also be noted that the duty cycle can be calculated to be greater than 100%. If a duty cycle is calculated to be greater than 100%, then the duty cycle scheduler will generate a result of 100%, whereby a resulting control action enables the high flow solenoid valve 204 such that solenoid valve is in an "ON" state for 100% of the predefined period, and the air solenoid valve 203 is in an "OFF" state.

Subsequently, in the next period, the duty cycle may be reduced, such that a smaller time proportion of fluid is output. In this case, the high flow fluid valve 204 will be open for some time less than the full 4 second interval, and the air solenoid valve 203 will be open for some time during the interval to allow air to flow to the chuck 10.

In general, a duty cycle is calculated by the duty cycle scheduler every predefined period. Therefore, as the measured temperature approaches the desired temperature, the duty cycle will gradually be reduced. The temperature controller 30 will control the air solenoid valve 203 and the high flow solenoid valve 204 accordingly such that the proportion of water to air continues to decrease as the measured temperature approaches the desired temperature.

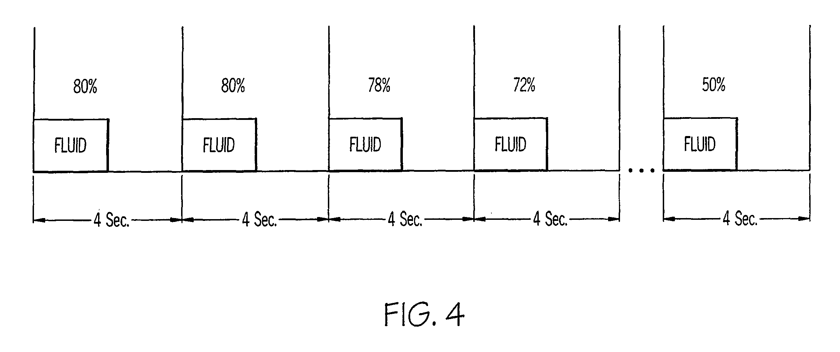

FIG. 4 contains a graph illustrating the temperature controller 30 performing a series of control actions comprising alternating air and fluid in a series of predefined periods or time intervals according to the present invention. In FIG. 4, a duty cycle calculation is performed during each 4 second period of the temperature. FIG. 4 is not drawn to scale, in particular with regard to the illustrated duty cycles. Instead, emphasis is placed upon illustrating the principles of the invention. The fluid time proportions shown in the figure are for illustrative purposes only.

FIG. 4 illustrates a temperature transition from a high temperature to a low temperature. When the measured temperature is much higher than the desired temperature, the fluid proportion will be relatively high. For example, in FIG. 4, the initial 4-second period illustrates that the high flow solenoid valve 204 outputs water during 80% of the period. This is referred to as an 80% duty cycle or proportion or control effort. During the temperature transition in the example of FIG. 4, the duty cycle decreases in each period until the high flow solenoid valve 204 outputs fluid for 50% of the period. In each period, air is output by the air solenoid valve 203. For example, in the first period of FIG. 4, the air solenoid valve 203 outputs air to the chuck for 20% of the period.

The duty cycle scheduler calculates the duty cycle until the measured temperature enters a dead-band temperature region. At this point, the time proportional controller performs different calculations, referred to as a dead-band mode, and a secondary control action, in particular with regard to the combination of valve outputs. The applied secondary control action depends on the temperature range, and is described below.

While the gain scheduling, duty cycle scheduling, and dead-band mode functions result in a controlled temperature transition, undershoot can still occur, whereby the measured temperature is reduced until it is less than the desired set point temperature. A key feature of the present invention is that when undershoot occurs, the temperature controller 30 can quickly stabilize the measured temperature until steady-state. This is achieved by performing a cooling operation and a heating operation concurrently, both operations under the control of the temperature controller 30.

Thus, the cooling operation of the present invention is controlled by the time proportional controller to reduce the measured temperature until it enters the dead-band temperature range. At this point, the time proportional controller enters a dead-band mode, whereby a different control action occurs with regard to the combination of valve outputs. In addition, a heating operation may be concurrently applied in order to achieve the desired effect of minimum undershoot. Details regarding the concurrent heating operation are described below.

Another important feature of the present invention is that the time proportional controller divides the thermal chuck temperature range into the plurality of control regions. The thermal chuck temperature region, for example, ranges from 0°C to 300°C. Each control region is defined by an upper temperature boundary and a lower temperature boundary. In addition, each control region comprises a dead-band temperature region if the control region includes the desired set point temperature. As mentioned above, the dead-band temperature region is formed above and below the desired set point temperature, thereby forming a dead-band around the desired set point temperature.

In addition, each control region has a gain scheduler. The gain scheduler of each control region calculates a proportion band with respect to temperature characteristics exhibited by the control region. For example, a control region having a temperature range between 25°C and 60°C can exhibit different temperature characteristics than another control region having a temperature range above 150°C, for example, with regard to the forming of steam from fluid in the thermal chuck at different temperatures. In particular, the gain scheduler of control regions having a temperature above 110°C calculates a proportion band using a different calculation than the control regions having a temperature region below 110°C. The calculations performed by the gain scheduler in the various control regions are illustrated below.

In addition, if the desired temperature is in a control region having a high temperature range, a high undershoot can occur, as compared with a control region having a low temperature range, the low-temperature control region having a smaller undershoot than the high-temperature control region. However, the time proportional controller will execute control actions that are unique to the high-temperature control region, and can therefore minimize undershoot accordingly.

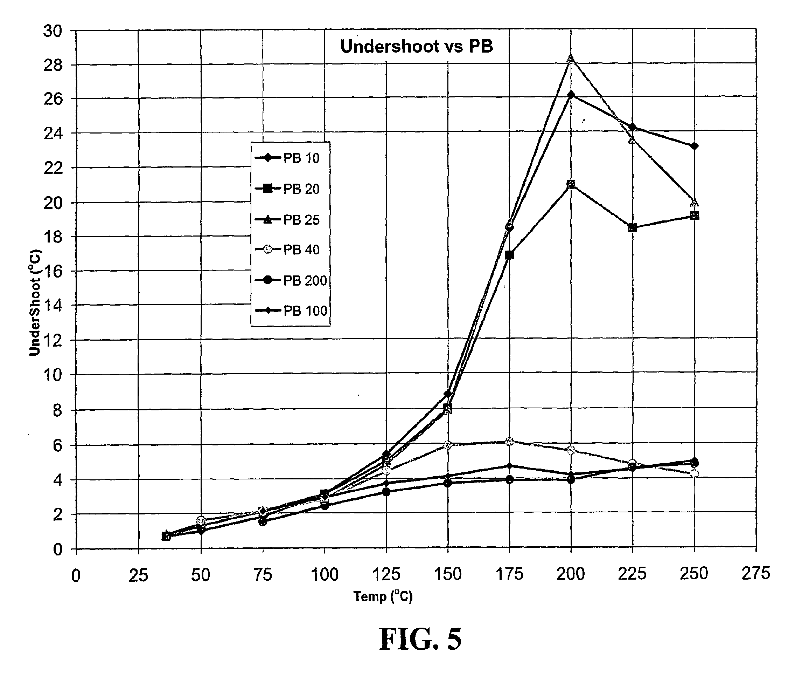

FIG. 5 contains a graph that illustrates undershoot at varying temperatures and six different fixed proportion bands, namely, PB 10, PB 20, PB 25, PB 40, PB 200, and PB 100, in the absence of the time proportional controller of the present invention. As shown in FIG. 5, an undershoot can be very large at high temperatures as compared with an undershoot at lower temperatures. For example, at 200° C, at a fixed gain (PB 25), an undershoot with conventional temperature control and no gain scheduling is 28° C. At 150°C, the undershoot at the same fixed gain (PB 25) is 8°C. FIG. 5 describes undershoot under different fixed gains, the fixed gains determined by various thermal chuck parameters.

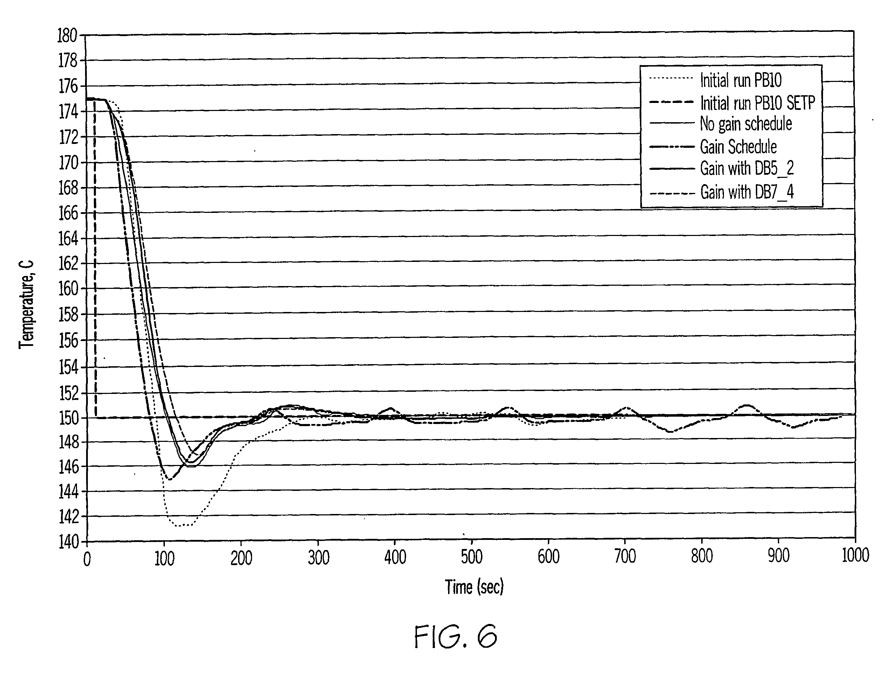

FIG. 6 contains a graph that shows the result of an undershoot with the gain scheduler, duty cycle scheduler, and dead-band mode of the thermal chuck system of the present invention. By introducing the temperature controller 30 of the present invention, the undershoot is improved.

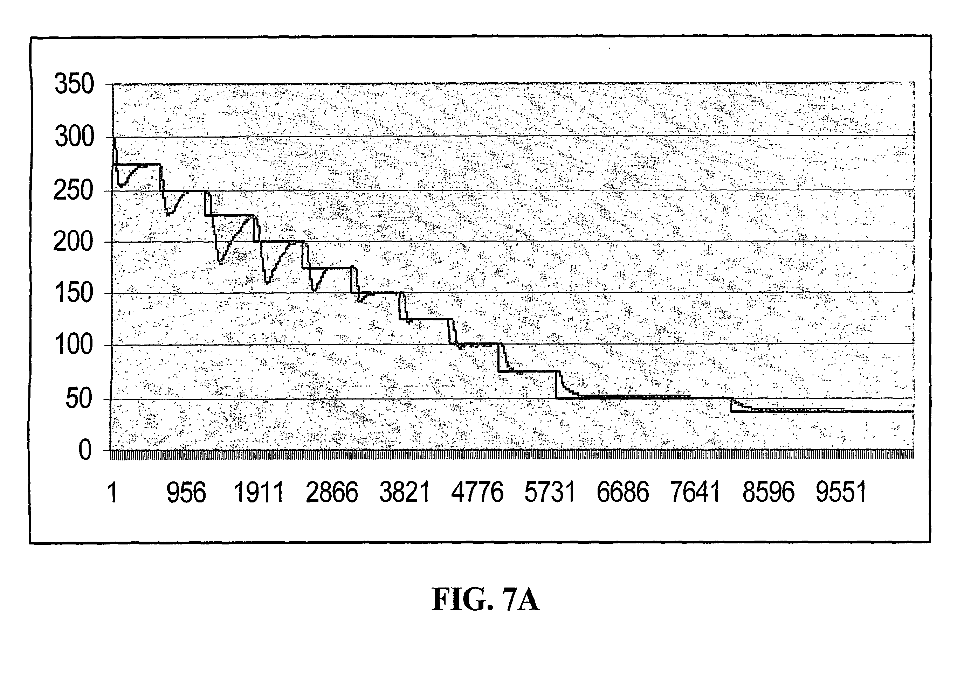

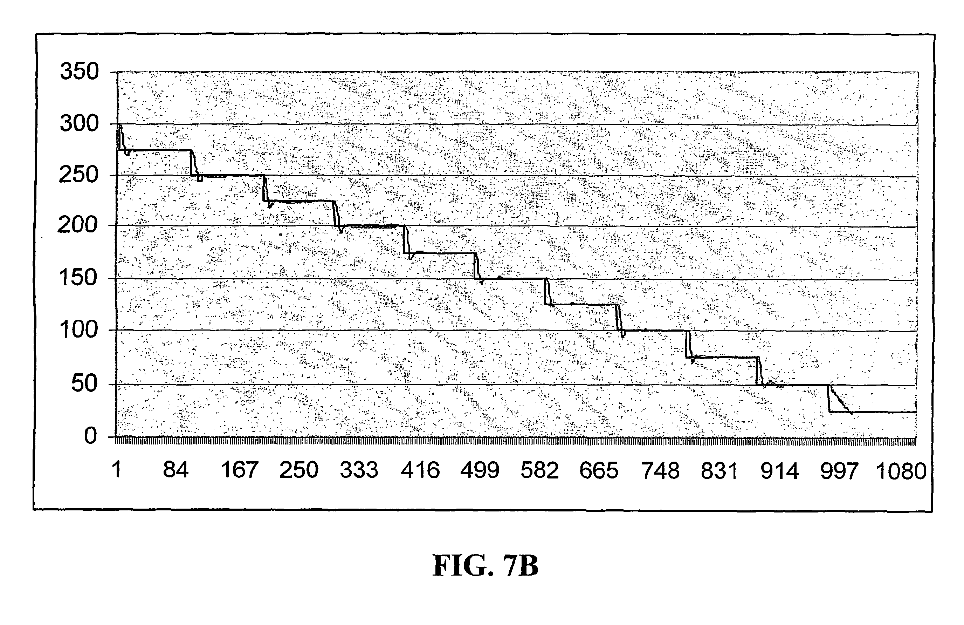

FIG. 7A contains a graph of undershoots resulting from multiple temperature transitions according to a conventional thermal chuck. FIG. 7B contains a graph of undershoots resulting from multiple temperature transitions according to the present invention.

FIGs. 5-7 therefore illustrate that by introducing the time proportional controller of the present invention, undershoot is improved over conventional thermal chuck systems, regardless of the temperature range between the measured temperature and the desired temperature. As described above, the time proportional controller of the temperature controller 30 can minimize undershoot by controlling a measured chuck temperature across the temperature range supported by the thermal chuck by partitioning the chuck temperature range into a plurality of control regions and low-temperature regions. This feature of the present invention is illustrated in the following example.

In this example, a thermal chuck temperature range is divided by the time proportional controller into five different control regions. Each control region comprises a gain scheduler. In addition, each control region in this example includes a dead-band temperature region. A low-temperature region (referred to in this example as "Control Region One") has a temperature region marked by a low temperature boundary of about 10° C to a high temperature boundary of about 25°C. During a temperature transition for decreasing the measured chuck temperature until a desired temperature is reached, when the measured chuck temperature is in Control Region One, a control action is performed that requires 100% fluid and 0% air to be provided to the thermal chuck 20 during the predefined period. Here, the temperature controller controls the valve control box 20 by placing the high flow solenoid valve 204 in an "ON" state and the air solenoid valve 203 in an "OFF" state. In addition, the low flow solenoid valve 205 is placed in an "OFF" state. Here, the high flow solenoid valve 204 is continually open, thus keeping the temperature-controlled fluid circulating through the thermal chuck, regardless of the measured temperature.

In Control Region One, 100% fluid and 0% air, is applied to the thermal chuck until a desired chuck temperature can be achieved. When the measured chuck temperature is reduced until the desired chuck temperature is achieved, the fluid temperature is maintained at a fixed temperature below the desired chuck temperature, for example, at 10°C below the desired chuck temperature.

During a cooling operation in Control Region One whereby the measured temperature is reduced until it is less than the desired temperature, and thus creating an undesirable undershoot, a heating operation may be performed.

During the heating operation, the fluid temperature is increased until the desired chuck temperature is achieved and steady state is achieved. To perform the heating operation, the heater 11 is placed under a closed loop temperature control. In this manner, the time proportional controller calculates the difference between the measured temperature and the desired temperature. The result is filtered using a proportional-integral-derivative (PID) topology. The PID is used by the temperature controller to command a heat power level that increases the measured temperature until it is at the desired temperature.

Therefore, the desired temperature may be achieved by applying the heating operation during the cooling operation, such that the heating operation and the cooling operation are performed together to reduce undershoot. Also, it may be necessary to apply the heating operation after the cooling operation is performed to maintain steady state.

The temperature transition can occur within Control Region One, wherein the measured temperature and the desired temperature both have a temperature that is in the Control Region One temperature region, for example, 10°C - 25°C, or the temperature transition can occur wherein the temperature transition is initiated from a control region having higher temperature regions than Control Region One. Here, the temperature transition operation in Control Region One is performed in the same manner. That is, the temperature controller controls the valve control box 20 by placing the high flow solenoid valve 204 in an "ON" state and the air solenoid valve 203 in an "OFF" state during a period where the measured temperature is in Control Region One. In Control Region One, the low flow solenoid valve 205 is placed in an "OFF" state, and the high flow solenoid valve 204 is continually open, or in an "ON" state, and thus temperature-controlled fluid is constantly circulating through the thermal chuck.

A second control region (referred to in this example as "Control Region Two") can be defined by a temperature range, for example, a temperature range marked by a low temperature boundary of about 25°C to a high temperature boundary of about 60°C.

During a temperature transition for decreasing the measured chuck temperature, i.e., a temperature cooling operation, when the measured chuck temperature is in the temperature range of Control Region Two, the time proportional controller performs a control action that alternates inputs of air and fluid to the thermal chuck in controlled proportions during a predefined period by enabling the air solenoid valve 203 and high flow solenoid valve 204 accordingly.

The proportions of air and fluid are determined by the gain scheduler and the duty cycle scheduler of the Control Region Two. In Control Region Two, the gain scheduler generates a proportion band (PB) and transition gain (TG), and the duty cycle scheduler generates a duty cycle (DC) in each predefined period, based on the following formulas:

$$\text{Proportion Band (PB)} = (K/10) * T_{chuck,0}/T_{range}$$

$$\text{Transition Gain (TG)} = 100/PB$$

$$\text{Duty Cycle (DC)} = -E * TG,$$

where E is the temperature error, defined by

$$E = T_{setpoint} - T_{chuck}$$

The constant K is a fixed gain value, having a default value, for example, a default value K of 270. K is an empirically determined constant based on undershoot performance during temperature transitions. It should be noted that the fixed constant K is reduced by a factor of 10 in Control Region Two to further compensate for inherent temperature behavior that occurs below the boiling point of water, in the temperature range of Control Region Two. Specifically, K is divided by 10 in Control Region Two because the fluid in the liquid state does not remove heat as quickly as the fluid in the gaseous state, i.e., steam. The chuck temperature ($T_{chuck,0}$) is an initial measured chuck temperature at the start of the temperature transition. $T_{range}$ is defined as the difference between the maximum chuck temperature, for example, 300°C, and the minimum water temperature, for example 0°C, which can also be regarded as the minimum chuck temperature. In this example, $T_{range} = 300$. $T_{setpoint}$ is the desired temperature. The error coefficient E is the difference between the desired temperature and the measured temperature. The chuck temperature $T_{chuck}$ is the instantaneous measured chuck temperature at a time during a transition.

For example, a temperature transition from 270°C to 40°C will result in a proportion band (PB) of 24.3 since $T_{chuck, 0}$ = 270. The transition gain (TG) = 4.115.

In the above example, a duty cycle (DC) calculated in the first period of the temperature transition, i.e., when the chuck temperature $T_{chuck}$ is 270°C, is DC = 4.115* (40-270) = 946.45%. As described above, the maximum duty cycle is 100%. Therefore, in the first period, a 100% duty cycle is used. In another example, when the measured temperature is 60°C, the duty cycle is 82.3%, indicating that the high flow solenoid valve 204 will output fluid to the chuck during 82.3% of the period, and the air solenoid valve 203 will be open during the remaining 17.7% of the period. The minimum value of the duty cycle is generally configured for 80% prior to entering the dead-band temperature region. That is, the high flow solenoid valve 204 is in an "ON" state for at least 80% of a predefined period.

The duty cycle scheduler maintains a minimum 80% duty cycle until the dead-band is reached. At that point, a minimum 50% duty cycle is used, i.e., proportions of 50% fluid and 50% air required for a predefined period. In the dead-band temperature region of Control Region Two, the duty cycle cannot be less than 50%. For example, when the desired temperature is 40°C and the measured temperature is 45°C, the duty cycle is calculated to be 20.57%. However, since this is less than the required 50% duty cycle, a minimum duty cycle of 50% must be maintained, such that proportions of 50% fluid and 50% are produced.

In the dead-band mode, the time proportional controller controls the air solenoid valve 203 and high-flow solenoid valve 204 such that a 50% duty cycle is achieved for a set period of time, for example, 5 minutes. In addition, heat is applied as necessary to stabilize the measured temperature. After the set period of time expires, Control Region Two places the low flow solenoid valve 205 in an "ON" state, in which a low flow of fluid is input to the thermal chuck. In this manner, when the chuck temperature is decreased such that the chuck temperature is in the dead-band region of Control Region Two, the low flow of fluid can remove heat from the controller by expelling fluid carrying heat from the thermal chuck 10 via an output port and fluid path 22 (FIG. 1), and introducing the low flow of fluid to the chuck 10 via a fluid input port and fluid path 21 (FIG. 1).

During a cooling operation in Control Region Two, the measured temperature may be reduced by the cooling operation until it is less than the desired temperature, and thus creating an undesirable undershoot. A heating operation is performed in a similar manner as the heating operation of Control Region One. That is, during the heating operation, the fluid temperature is increased until the desired chuck temperature is achieved.

When the thermal chuck system is at steady state, whereby the magnitude of the difference between the measured chuck temperature and the desired chuck temperature has a minimum predefined deviation, the low flow solenoid valve 205 remains in the "ON" state, thus keeping the fluid circulating through the thermal chuck 10 and thereby permitting the thermal chuck system to remain in steady state. The fluid temperature is maintained at a set temperature below the desired chuck temperature, for example, set at 10°C below the desired chuck temperature, or set at 35°C for desired chuck temperatures above 45°C.

Although the desired temperature may be achieved during a temperature cooling operation, whereby the thermal chuck system is at steady state, it may be necessary to perform a heating operation to maintain steady state, whereby the heating operation described above will be performed.

A third control region (referred to in this example as "Control Region Three") can be defined by a third temperature range, for example, a temperature range marked by a low temperature boundary of about 60° C to a high temperature boundary of about 110°C.

During a cooling operation, when the measured chuck temperature is in the temperature range of Control Region Three, a controller process of Control Region Three performs a control action that alternates inputs of air and fluid to the thermal chuck in controlled proportions during a predefined period by enabling the air solenoid valve 203 and high flow solenoid valve 204 accordingly.

The proportions of air and fluid are determined by the gain scheduler of Control Region Three. In Control Region Three, the gain scheduler generates a proportion band (PB) and transition gain (TG), and the duty cycle scheduler generates a duty cycle (DC) in each predefined period of a temperature transition, based on the following formulas:

$$\text{Proportion Band (PB)} = (K/10) * T_{chuck, 0} / T_{range}$$

$$\text{Transition Gain (TG)} = 100/PB$$

$$\text{Duty Cycle (DC)} = -E * TG,$$

EP 1 861 759 B1

where E is the temperature error, defined by

$$E = T_{setpoint} - T_{chuck}$$

The constant K is a fixed gain value, having a default value, for example a default value of 270. K is an empirically determined constant based on undershoot performance during temperature transitions. It should be noted that the fixed constant K is reduced by a factor of 10 in Control Region Three to further compensate for inherent temperature behavior that occurs in the temperature range of Control Region Three, for reasons similar to Control Region Two. The chuck temperature ($T_{chuck, 0}$) is an initial measured chuck temperature at the start of the temperature transition. $T_{range}$ is defined as the difference between the maximum chuck temperature, for example, 300°C, and the minimum water temperature, for example 0°C, which can also be regarded as the minimum chuck temperature. In this example, $T_{range}$ = 300. $T_{setpoint}$ is the desired set point temperature. The error coefficient E is the difference between the desired temperature and the measured temperature. The chuck temperature $T_{chuck}$ is the instantaneous measured chuck temperature at a time during a transition.

For example, a temperature transition from 250°C to 100°C will result in a proportion band (PB) of 22.5. The transition gain (TG) at this proportion band is 4.44. When the measured temperature is 250°C during the temperature transition, the duty cycle is calculated by the duty cycle scheduler as (100-250)*4.44 = 666% . As described above, a maximum duty cycle of 100% is permitted. Therefore, the high flow solenoid valve 204 will output fluid to the chuck during 100% of the period. At 115°C during the transition, the duty cycle is calculated to be 66.6%. At 110°C , the duty cycle is calculated to be 44.4%.

In addition, Control Region Three includes a dead-band temperature region when the desired chuck temperature is in the temperature range of Control Region Three, for example between 60°C and 110°C. When the measured chuck temperature enters the dead-band temperature region of Control Region Three, the thermal chuck system enters a proportional air/low flow fluid state for a fixed duration. The fixed duration is adjustable, but is generally configured at 10 minutes. In the proportional air/low flow fluid state, the time proportional controller of Control Region Three alternates inputs of air and fluid to the chuck in controlled proportions by enabling the air solenoid valve 203 and low flow solenoid valve 205 for the fixed duration. The alternating proportions of air and low flow fluid to the chuck in this manner reduces the undershoot that occurs during the temperature transition. After the duration expires, the air solenoid valve is enabled for 30 seconds to purge the chuck 10 of any fluid. Here, the controller process places the high flow solenoid valve 204 and the low flow solenoid valve 205 in an "OFF" state, and the air solenoid valve 203 is enabled, that is, in an "ON" state.

During the cooling operation, whereby the measured temperature is less than the desired temperature, and thus creating an undesirable undershoot, a heating operation is applied to stabilize the measured temperature, i.e., to minimize the undershoot.

After the previously described cooling actions occur, the thermal chuck system settles to steady state. When the system is at steady state, valves 203, 204, 205 are disabled, or in an "OFF" state. At this time, no air or fluid flows through the chuck. However, like Control Regions One and Two, it may be necessary to perform a heating operation to maintain steady state. The heating operation may be performed in a manner similar to the heating operation described above with regard to the low-temperature regions.

When the measured chuck temperature reaches the dead-band temperature region in Control Region Three, the thermal chuck system enters a proportional air controlled state for a fixed duration. The fixed duration is user-configurable, but is generally configured at 10 minutes. Here, the high flow solenoid valve 204 and low flow solenoid valve 205 are disabled, that is, an "OFF" state. The air solenoid valve 203 is alternately enabled and disabled such that air is introduced to the chuck in controlled proportions, according to a duty cycle calculated by the duty cycle scheduler. The measured temperature is thereby increased until the desired chuck temperature is achieved.

After the cooling and heating operations above are performed, the thermal chuck system settles to steady state. When the thermal chuck system is at steady state, the valves 203, 204, 205 in the system are disabled, that is, an "OFF" state. In this manner, no air or fluid flows through the chuck.

A fourth control region (referred to as "Control Region Four") can be defined by a fourth temperature range above the third control region. The temperature range of Control Region Four is marked, for example, by a low temperature boundary of 110° C and a high temperature boundary of 150°C.

During a cooling operation when the measured chuck temperature is in the temperature range of Control Region Four, a controller process of Control Region Four performs a control action that alternates inputs of air and fluid to the chuck in controlled proportions during a predefined period by enabling the air solenoid valve 203 and high flow solenoid valve 204 accordingly.

The proportions of air and fluid are determined by the gain scheduler of the Control Region Four controller process. In Control Region Four, the gain scheduler generates a proportion band (PB) and transition gain (TG), and the

13

duty cycle scheduler generates a duty cycle (DC) in each predefined period of a temperature transition, based on the following formulas:

$$\text{Proportion Band (PB)} = K * T_{chuck,\,0} / T_{range}$$

$$\text{Transition Gain (TG)} = 100/PB$$

$$\text{Duty Cycle (DC)} = -E * TG,$$

where E is the temperature error, defined by

$$E = T_{setpoint} - T_{chuck}$$

The constant K is a fixed gain value, having a default value, for example a default value of 270. The chuck temperature ($T_{chuck,\,0}$) is an initial measured chuck temperature at the start of the temperature transition. $T_{range}$ is defined as the difference between the maximum chuck temperature, for example, 300°C, and the minimum fluid and chuck temperature, for example 0°C, which can also be regarded as the minimum chuck temperature. In this example, $T_{range}$ = 300. $T_{setpoint}$ is the desired set point temperature. The error coefficient E is the difference between the desired temperature and the measured temperature. The chuck temperature $T_{chuck}$ is the instantaneous measured chuck temperature at a time during a transition.

In addition, Control Region Four includes a dead-band temperature region when the desired chuck temperature is in the temperature range of Control Region Four. When the measured chuck temperature enters the dead-band temperature region of Control Region Four during a cooling temperature transition, the thermal chuck system enters a proportional air/low flow fluid state for a fixed duration, for example, 10 minutes. In the proportional air/low flow fluid state, the controller process of Control Region Four alternates inputs of air and fluid to the chuck in controlled proportions by enabling the air solenoid valve 203 and low flow solenoid valve 205 for the fixed duration. The alternating proportions of air and low flow fluid to the chuck in this manner further reduces the undershoot that occurs during the temperature transition. As in Control Region Three, the air solenoid valve is enabled when the duration expires to purge the chuck 10 of any fluid. Here, the controller process places the high flow solenoid valve 204 and the low flow solenoid valve 205 in an "OFF" state, and the air solenoid valve 203 is in an "ON" state.

During the cooling operation, whereby the measured temperature is less than the desired temperature, and thus creating an undesirable undershoot, in a manner similar to Control Region Three, a heating operation may be performed in tandem with the cooling operation to stabilize the measured temperature, or to minimize the undershoot.

After the cooling and heating operations above are performed, the thermal chuck system settles to steady state. When the thermal chuck system is at steady state, the solenoid valves 203, 204, 205 in the system are disabled, that is, an "OFF" state. At this time, no air or fluid flows through the chuck.

A fifth control region (referred to as "Control Region Five") can be defined by a fifth temperature range, for example, a temperature range marked by a low temperature boundary of 150° C to a high temperature boundary of 300°C.

During a cooling operation when the measured chuck temperature is in the temperature range of Control Region Five, a controller process of Control Region Five performs a control action that alternates inputs of air and fluid to the chuck in controlled proportions during a predefined period by enabling the air solenoid valve 203 and high flow solenoid valve 204 accordingly.

The proportions of air and fluid are determined by the duty cycle scheduler of the Control Region Five controller process. In Control Region Five, the gain scheduler generates a proportion band (PB) and transition gain (TG), and the duty cycle scheduler generates a duty cycle (DC) in each predefined period of a temperature transition, based on the following formulas:

$$\text{Proportion Band (PB)} = K * T_{chuck,\,0} / T_{range}$$

$$\text{Transition Gain} = 100/PB$$

$$\text{Duty Cycle (DC)} = -E * TG,$$

where E is the temperature error, defined by

$$E = T_{setpoint} - T_{chuck}$$

The constant K is a fixed gain value, having a default value, for example a default value of 270. The initial chuck temperature ($T_{chuck, 0}$) is a the initial measured chuck temperature at the start of the temperature transition. $T_{range}$ is defined as the difference between the maximum chuck temperature, for example, 300°C and the minimum water and chuck temperature, for example 0°C. In this example, $T_{range}$ = 300. The error coefficient (E) is the difference between the desired temperature and the measured temperature. The error coefficient E is the difference between the desired temperature and the measured temperature. The chuck temperature $T_{chuck}$ is the instantaneous measured chuck temperature at a time during a transition.

Control Region Five includes a dead-band temperature region when the desired measured temperature is in the temperature range of Control Region Five. When the measured chuck temperature enters the dead-band temperature region of Control Region Five during a cooling temperature transition, the time proportional controller of Control Region Five enables the air solenoid valve 203, whereby the air solenoid valve 203 is in an "ON" state, to expel fluid from the chuck. At this point, the high flow solenoid 204 and low flow solenoid 205 valves are in an "OFF" state. It is important that the fluid is expelled from the thermal chuck 10 in the temperature range of Control Region Five due to the risk of steam being formed in the temperature range of Control Region Five which may create instability with regard to the operation of the chuck 10. Thus, as distinguished from Control Regions One, Two, Three, and Four, no fluid exists in the chuck when the measured temperature is in the Control Region Five dead-band temperature region.

After the fluid is purged from the chuck, the thermal chuck system enters a proportional air controlled state for a fixed duration. The fixed duration is adjustable, but is generally configured at 10 minutes. Here, the high flow solenoid valve 204 and low flow solenoid valve 205 are disabled, that is, an "OFF" state. The air solenoid valve 203 is alternately enabled and disabled such that cold air is provided to the thermal chuck 10 in controlled proportions, according to a calculated air proportional band, for example, a 2°C proportional band. The air solenoid valve 203 remains in the "ON" state for the fixed duration in order to stabilize the chuck temperature for latent heat. The air solenoid valve 203 is in the "ON" state for a proportion of the fixed duration, and the high flow solenoid 204 and low flow solenoid 205 valves remain in the "OFF" state. Once the period has expired, the air solenoid valve 203 is disabled, that is, an "OFF" state.

During the cooling operation, whereby the measured temperature is less than the desired temperature, and thus creating an undesirable undershoot, a heating operation may be performed in addition to the cooling operation to stabilize the measured temperature, that is, to minimize the undershoot.

After the described cooling actions, the thermal chuck system settles to steady state. When the thermal chuck system is at steady state, the solenoid valves 203, 204, 205 are disabled, that is, an "OFF" state. In this manner, no air or fluid flows through the chuck.

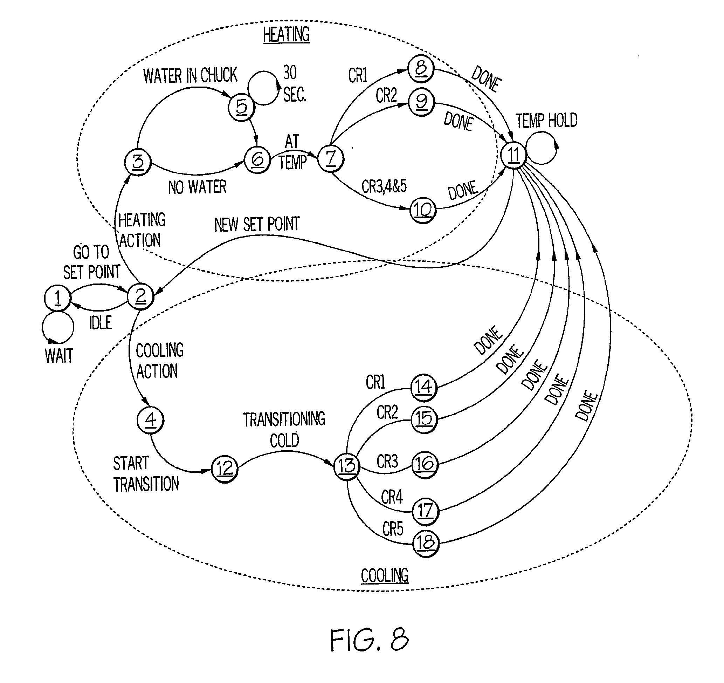

FIG. 8 contains a state diagram illustrating temperature transition results occurring in a plurality of control regions according to the present invention. Control Region One through Control Region Five used in the previous example are applicable in this illustration.

In state 1, the temperature controller 30 is in an idle state. There are no active temperature operations. The temperature controller 30 generates an instruction to the fluid source 40 to maintain a fluid temperature of 5°C. Valves 203, 204, and 205 are off. Heater 11 is off.

In state 2, the temperature controller 30 receives a temperature transition instruction. Valves 203, 204, 205, and heater 11 are off. If the instruction is to perform a temperature transition including a heating operation, then the temperature controller 30 performs the heating operation beginning at state 3. If the instruction is to perform a temperature transition including a cooling operation, then the temperature controller 30 performs the cooling operation beginning at state 4.

In state 3, the temperature controller 30 receives a temperature transition instruction to perform a heating operation. A control decision is made concerning whether the chuck 10 contains fluid. If yes, then the temperature controller enters state 5. If no, then the temperature controller 30 enters state 6. Valves 203, 204, 205, and heater 11 are off.

In state 5, the temperature controller 30 purges fluid from the chuck for 30 seconds. Air solenoid valve 203 is in an "ON" state. High flow solenoid valve 204 and low flow solenoid valve 205 are in an "OFF" state. Heater power is enabled, and the heater 11 is under a closed loop temperature control, as described above.

In state 6, the heater 11 warms the chuck to the desired temperature. When the desired temperature, or set point temperature, is reached, valves 203, 204, 205 are in an "OFF" state and the heater is under a closed loop temperature control. The temperature controller 30 generates an instruction to the fluid source 40 to maintain a temperature of the fluid at 10°C below the desired chuck temperature, within a temperature range between 5°C and 35°C. If the chuck desired temperature is in Control Region Three, Four, or Five, the temperature controller generates an instruction to the fluid source 40 to maintain a fluid temperature of 5°C.

In state 7, a control action is performed by the temperature controller based on the desired temperature. If the desired temperature is in Control Region One, then a control action is performed at state 8. If the desired temperature is in Control Region Two, then a control action is performed at state 9. If the desired temperature is in Control Region Three, Four, or Five, then a control action is performed at state 10.

In state 8, the measured temperature and desired temperature are both in Control Region One, for example, at temperatures between 10°C - 25°C. The high flow solenoid valve 204 is in an "ON" state. Valves 203, 205 are in an "OFF" state. The chuck temperature is increased until the desired temperature is reached. Since fluid is continuously running through the chuck 10 in Control Region One, heat is applied by heater 11 to maintain a precise desired temperature such that the temperature deviation between the measured temperature and desired temperature is approximately 0°C.

In state 9, the measured temperature and desired temperature are both in Control Region Two, for example, at temperatures between 25°C - 60°C. In this state, the low flow solenoid valve 205 is in an "ON" state. Valves 203, 204 are in an "OFF" state. The chuck temperature is increased until the desired temperature is reached. Since fluid is continuously running through the chuck 10 in Control Region One, heat is applied by heater 11 to maintain a precise desired temperature such that the temperature deviation between the measured temperature and desired temperature is approximately 0°C.

In state 10, the measured temperature and desired temperature is in Control Region Three, Four, or Five, for example, at temperatures above 60°. The time proportional controller 30 performs proportion band calculations as described above, if the measured temperature is lower than the desired temperature. During a heating operation, for example, to maintain steady state, the heating operation may be performed in a manner similar to the heating operation described above with regard to the low temperature regions. In this manner, the measured temperature is increased until the desired chuck temperature is achieved. The temperature controller conducts a heating operation as necessary to maintain a precise desired temperature.

In state 11, the temperature transitions of states 8, 9, and 10 are completed. In this state, the measured temperature is at steady state. The temperature controller 30 remains at state 11 until a new temperature transition instruction is received, then the temperature controller 30 proceeds to state 2.

In state 4, the temperature controller 30 receives a temperature transition instruction to perform a cooling operation. The fluid source 40 is instructed to maintain a temperature of 5°C. The heater 11 is off. A gain scheduler calculates a proportion band and transition gain to be used for the duration of the temperature transition by the time proportional controller. In addition, a duty cycle scheduler calculates a duty cycle for each period of the temperature transition for controlling the valves 203, 204, 205 accordingly.

In state 12, air solenoid valve 203 and high flow solenoid valve 204 are enabled and disabled according to calculated time proportions, as described above. The heater 11 is off. The temperature controller 30 determines the dead-band temperature region from the desired temperature and a predetermined dead-band. For example, if the dead-band is +/-5°C, then the dead-band temperature region is the desired set point temperature +/- 5°C. Upon reaching the dead-band temperature range, a secondary control action, in particular a dead-band mode control action, is executed accordingly, as described above. The heater 11 is off.

In state 13, a secondary control action is performed by the temperature controller 30 based on the desired temperature. If the desired temperature is in Control Region One, then the secondary control action is performed at state 14. If the desired temperature is in Control Region Two, then the secondary control action is performed at state 15. If the desired temperature is in Control Region Three, then the secondary control action is performed at state 16. If the desired temperature is in Control Region Four, then the secondary control action is performed at state 17. If the desired temperature is in Control Region Five, then the secondary control action is performed at state 18.

In state 14, the control actions as described above in Control Region One are performed. Specifically, when the measured temperature reaches the desired temperature, the high flow solenoid valve 204 is enabled, and the heater 11 is enabled. In addition, the fluid source 40 is instructed to maintain a fluid temperature at 10°C below the desired set point temperature, bounded by a low temperature boundary of 5°. The temperature controller controls the heater 11 to maintain a precise temperature by adding heat to offset the fluid temperature such that the temperature deviation between the measured temperature and the desired temperature is approximately 0°C.

In state 15, the control actions as described above in Control Region Two are performed. Specifically, when the measured temperature reaches the desired temperature in the dead-band temperature region of Control Region Two, the time proportional controller performs a control action based on a 50% duty cycle, as described above. The fluid source 40 is instructed to maintain a temperature of the desired temperature minus 10°C, bounded by a low temperature boundary of 5°. The temperature controller controls the heater 11 to maintain a precise temperature by adding heat to offset the fluid such that the temperature deviation between the measured temperature and the desired temperature is approximately 0°C.

In state 16, the control actions as described above in Control Region Three are performed. Specifically, the duty cycle scheduler calculates a duty cycle for each period that the measured temperature is higher than the desired temperature in a cooling operation. When the measured temperature reaches the desired temperature in the dead-band temperature region of Control Region Three, the time proportional controller performs a control action by applying the low flow solenoid valve 205 and air solenoid valve 203, as described above. In addition, the fluid source 40 is instructed to maintain a temperature of 5°C until the measured temperature reaches steady state. After a ten minute timer expires, referred to above as a duration, the low flow solenoid valve 205 is in an "OFF" state, and the air solenoid valve 203 enabled, in an "ON" state, for 30 seconds to expel any fluid from the chuck. The temperature controller controls the heater 11 to maintain a precise temperature by adding heat to offset the fluid such that the temperature deviation between the measured temperature and the desired temperature is approximately 0°C.

In state 17, the control actions as described above in Control Region Four are performed, as illustrated above. Specifically, the duty cycle scheduler calculates a duty cycle for each period that the measured temperature is higher than the desired temperature in a cooling operation. When the measured temperature is in Control Region Four, the time proportional controller performs a control action that alternates inputs of air and fluid to the chuck 10 in controlled proportions by enabling the air solenoid valve 203 and high flow solenoid valve 204 accordingly. In addition, when the measured temperature reaches the desired temperature in the dead-band region of Control Region Four, the controller process alternates inputs of air and fluid in the chuck in controlled proportions by enabling the air solenoid valve 203 and low flow solenoid valve 205 for a fixed duration, for example, 10 minutes. As in Control Region Three, the air solenoid valve 203 is enabled when the duration expires to purge the chuck 10 of any fluid. Here, the high flow solenoid valve 204 and low flow solenoid valve 205 are in an "OFF" state, and the air solenoid valve is in an "ON" state.

In state 18, the control actions as described above in Control Region Five are performed. Specifically, the gain scheduler calculates a proportion band if the measured temperature is higher than the desired temperature. When the measured temperature reaches the desired temperature, the heater 11 is enabled. Valves 203, 204, 205 are in an "OFF" state. In addition, the fluid source 40 is instructed to maintain a temperature of 5°C until the measured temperature reaches steady state. The temperature controller controls the heater 11 to maintain a precise temperature by adding heat to offset the fluid such that the temperature deviation between the measured temperature and the desired temperature is approximately 0°C.

## Claims

1. A temperature control system for a chuck (10), **characterized by** comprising:

    a first input for receiving air from an air source;
    a second input (24) for receiving a fluid from a fluid source (40); and
    at least one output (21) for alternately transferring the air and fluid to the chuck to control a surface temperature of the chuck, the air transferred through the at least one output having a first proportion of time of a predetermined period of time, and the fluid transferred through the at least one output having a second proportion of time of the predetermined period of time.

2. The temperature control system of claim 1, wherein

    a) the fluid is temperature-controlled, or
    b) the fluid comprises water, or
    c) the chuck is one of a 200mm and a 300mm thermal chuck.

3. The temperature control system of claim 1 or 2 further comprising:

    a first temperature control system (342) for controlling an increase of the surface temperature; and
    a second temperature control system (20) for controlling a decrease of the surface temperature by alternating the air and fluid in the first and second proportions of time during the predefined period of time the second temperature control system including low-temperature processes and controller processes for managing temperature transitions among a plurality of control regions.

**4.** The system of claim 3 further comprising a valve control box (20) and a time proportional controller (343).

**5.** The system of claim 4 wherein

a) the valve control box comprises an air valve (203) for outputting the air and a fluid valve (205) for outputting the temperature-controlled fluid, especially wherein the fluid valve is at least one of a high flow solenoid valve and a low flow solenoid valve, or wherein the air valve and the fluid valve outputs the air and fluid in an alternating mode in response to the controller, or
b) the valve control box further includes a base air valve (208) for providing a base cooling, or
c) the time proportional controller comprises:

an interface (341) for receiving measured temperature information from the thermal chuck;
a control region processor (302) for defining the plurality of control regions and a plurality of low-temperature regions;
a controller process in each control region; and
a low-temperature process in each low-temperature region, especially wherein the control region processor defines each control region and low-temperature region by temperature boundaries.

**6.** The system of claim 3, wherein when a first temperature is in a first control region of the plurality of control regions, a first controller process of the first control region adjusts the air and fluid proportions, and wherein when the first temperature is transitioned to a second temperature in a second control region, a second controller process of the second control region adjusts the air and fluid proportions.

**7.** The thermal chuck system of claim 6, wherein

a) the first control region and the second control region are the same, or
b) the first control region and the second control region are different control regions in the plurality of control regions, or
c) a dead-band region in the second control region provides an approximate temperature region of the second temperature, and wherein the second controller process controls the dead-band region to reduce an undershoot during the transition from the first temperature to the second temperature, especially wherein the second controller process reduces the undershoot by alternating the first input of air and the second input of fluid in proportions, or wherein the second controller process reduces the undershoot by disabling the first input of air and the second input of fluid.

**8.** The system of claim 3

a) further comprising temperature sensors for providing chuck temperature measurements to the thermal chuck system, or
b) wherein each controller process comprises a gain scheduler that computes a proportion band during the predefined period, wherein the proportion band determines the proportions of air and fluid input to the chuck during the predefined period, and wherein the proportion band is calculated in response to the chuck temperature measurements.

**9.** A method for controlling a chuck temperature **characterized by** comprising:

receiving air from an air source;
receiving fluid from a fluid source (40); and
alternately transferring the air and fluid to the chuck (10), the air transferred through an at least one output having a first proportion of time of a predetermined period of time, and the fluid transferred through the at least one output having a second proportion of time of the predetermined period of time.

**10.** The method of claim 9 further comprising controlling a temperature of the fluid.

**11.** The method of claim 9 or 10 further comprising:

controlling an increase of a surface temperature of the chuck; and
controlling a decrease of the surface temperature by alternating the air and fluid in the first and second proportions of time during the predefined period of time.

**12.** The method of claim 11,

a) further comprising managing temperature transitions among a plurality of control regions, or
b) wherein the air and fluid are outputted in an alternating mode in response to a time proportional controller, especially wherein the method further comprises receiving measured temperature information from the chuck, or
c) wherein each control region and low-temperature region is defined by temperature boundaries, or
d) further comprising computing a proportion band during the predefined period, wherein the proportion band determines the proportions of air and fluid input to the chuck during the predefined period, and wherein the proportion band is calculated in response to the chuck temperature measurements.

**13.** The method of claim 11 further comprising adjusting air and fluid proportions in a first control region of the plurality of control regions when a first temperature is in the first control region, wherein when the first temperature is transitioned to a second temperature in a second control region, adjusting air and fluid proportions in the second control region.

**14.** The method of claim 13

a) wherein the first control region and the second control region are the same, or
b) wherein the first control region and the second control region are different control regions in the plurality of control regions, or
c) further comprising providing an approximate temperature region as a dead-band region in the second control region for the second temperature, and controlling the dead-band region to reduce an undershoot during the transition from the first temperature to the second temperature, especially wherein the method further comprises reducing the undershoot by alternating the air and fluid in proportions, or wherein the method further comprises reducing the undershoot by disabling an input of air and an input of fluid.

**Patentansprüche**

**1.** Temperaturregelungssystem für eine Spanneinrichtung (10), **dadurch gekennzeichnet, dass** sie umfasst:

einen ersten Einlass zum Aufnehmen von Luft von einer Luftquelle;
einen zweiten Einlass (24) zum Aufnehmen eines Fluids von einer Fluidquelle (40); und
wenigstens einen Auslass (21), um alternativ die Luft und das Fluid zur Spanneinrichtung zu überführen, um eine Oberflächentemperatur der Spanneinrichtung zu regeln, wobei die über den wenigstens einen Auslass überführte Luft einen ersten Zeitanteil mit einer vorher bestimmten Zeitdauer hat und das über den wenigstens einen Auslass überführte Fluid einen zweiten Zeitanteil mit einer vorher bestimmten Zeitdauer hat.

**2.** Temperaturregelungssystem nach Anspruch 1, bei dem

a) das Fluid temperatur-geregelt ist, oder
b) das Fluid Wasser umfasst, oder
c) die Spanneinrichtung eine aus einer thermischen Spanneinrichtung mit 200 mm oder 300 mm ist.

**3.** Temperaturregelungssystem nach Anspruch 1 oder 2, ferner umfassend:

ein erstes Temperaturregelungssystem (342) zum Regeln einer Erhöhung der Oberflächentemperatur; und
ein zweites Temperaturregelungssystem (20) zum Regeln einer Erniedrigung der Oberflächentemperatur durch Abwechseln der Luft und des Fluids in den ersten und zweiten Zeitanteilen während der vorher definierten Zeitdauer, wobei das zweite Temperaturregelungssystem Niedrigtemperaturprozesse und Regelungsprozesse zum Verwalten von Temperaturübergängen unter einer Mehrzahl von Regelungsbereichen beinhaltet.

**4.** System nach Anspruch 3, ferner umfassend ein Ventilsteuerungsgerät (20) und eine Zeitverhältnis-Steuerungseinrichtung (343).

**5.** System nach Anspruch 4, bei dem

a) das Ventilsteuerungsgerät ein Luftventil (203) zum Auslassen der Luft und ein Fluidventil (205) zum Auslassen des Temperatur-geregelten Fluids umfasst, insbesondere wobei das Fluidventil wenigstens eines aus einem Magnetventil mit hohem Durchsatz und einem Magnetventil mit geringem Durchsatz ist, oder wobei das Luftventil und das Fluidventil die Luft und das Fluid in einem abwechselnden Modus in Antwort auf die Steuerungseinrichtung auslassen, oder

b) das Ventilsteuerungsgerät ferner ein Basis-Luftventil (208) zum Bereistellen einer Basiskühlung beinhaltet, oder

c) die Zeitverhältnis-Steuerungseinrichtung umfasst:

eine Schnittstelle (341) zum Empfangen von Information über die gemessene Temperatur von der thermischen Spanneinrichtung;

einen Steuerungsbereich-Prozessor (302) zum Definieren der Mehrzahl von Steuerungsbereichen und einer Mehrzahl von Niedertemperaturbereichen;

einen Steuerungseinrichtungsprozess in jedem Steuerungsbereich; und

einen Niedertemperaturprozess in jedem Niedertemperaturbereich, insbesondere wobei der Steuerungsbereich-Prozessor jeden Steuerungsbereich und Niedertemperaturbereich durch Temperaturgrenzen definiert.

6. System nach Anspruch 3, bei dem, wenn in einem ersten Steuerungsbereich der Mehrzahl von Steuerungsbereichen eine erste Temperatur herrscht, ein erster Steuerungseinrichtungsprozess des ersten Steuerungsbereichs die Luft- und Fluidanteile einstellt, und bei dem, wenn die erste Temperatur zu einer zweiten Temperatur in einem zweiten Steuerungsbereich übergegangen ist, ein zweiter Steuerungseinrichtungsprozess des zweiten Steuerungsbereiches die Luft- und Fluidanteile einstellt.

7. Thermisches Spanneinrichtungssystem nach Anspruch 6, bei dem

a) der erste Steuerungsbereich und der zweite Steuerungsbereich die gleichen sind, oder

b) der erste Steuerungsbereich und der zweite Steuerungsbereich verschiedene Steuerungsbereiche in der Mehrzahl von Steuerungsbereichcn sind, oder

c) ein Totzonenbereich im zweiten Steuerungsbereich einen angenäherten Temperaturbereich für die zweite Temperatur bereitstellt, und wobei der zweite Steuerungseinrichtungsprozess den Totzonenbereich steuert, um einen Einbruch während des Übergangs von der ersten Temperatur zur zweiten Temperatur zu verringern, insbesondere wobei der zweite Steuerungseinrichtungsprozess den Einbruch verringert, indem der erste Einlass für Luft und der zweite Einlass für Fluid abgewechselt werden, oder wobei der zweite Steuerungseinrichtungsprozess den Einbruch verringert, indem der erste Einlass für Luft und der zweite Einlass für fluid abgeschaltet werden.

8. System nach Anspruch 3

a) ferner umfassend Temperatursensoren zum Bereistellen von Spanneinrichtungstemperaturmessungen für das thermische Spanneinrichtungssystem, oder

b) wobei jeder Steuerungseinrichtungsprozess ein Zunahmesteuerprogramm umfasst, das ein Verhältnisband während der vorher definierten Dauer berechnet, wobei das Verhältnisband die Anteile von Luft- und Fluideinlass zur Spanneinrichtung während der vorher definierten Dauer ermittelt und wobei das Verhältnisband in Antwort auf die Spanneinrichtungstemperaturmessungen berechnet wird.

9. Verfahren zum Regeln einer Spanneinrichtungstemperatur, **dadurch gekennzeichnet, dass** es umfasst:

Empfangen von Luft von einer Luftquelle

Empfangen von Fluid von einer Fluidquelle (40); und

abwechselndes Überführen der Luft und des Fluids zur Spanneinrichtung (10), wobei die über einen wenigstens einen Auslass überführte Luft einen ersten Zeitanteil mit einer vorherbestimmten Zeitdauer hat und das über den wenigstens einen Auslass überführte Fluid einen zweiten Zeitanteil mit einer vorherbestimmten Zeitdauer hat.

10. Verfahren nach Anspruch 9, ferner umfassend das Steuern einer Temperatur des Fluids.

11. Verfahren nach Anspruch 9 oder 10, ferner umfassend:

Steuern einer Erhöhung der Oberflächentemperatur der Spanneinrichtung; und
Steuern einer Abnahme der Oberflächentemperatur durch Abwechseln der Luft und des Fluids in den ersten und zweiten Zeitanteilen während der vorher definierten Zeitdauer.

**12.** Verfahren nach Anspruch 11

a) ferner umfassend ein Verwalten von Temperaturübergängen- unter einer Mehrzahl von Steuerungsbereichen, oder
b) bei dem die Luft und das Fluid in abwechselndem Modus in Antwort auf eine Zeitanteilssteuerungseinrichtung ausgelassen werden, insbesondere wobei das Verfahren ferner das Empfangen von Informationen über eine gemessene Temperatur von der Spanneinrichtung umfasst, oder
c) wobei jeder Steuerungsbereich und Niedertemperaturbereich durch Temperaturgrenzen definiert ist, oder
d) ferner umfassend ein Berechnen eines Verhältnisbandes während der vorher definierten Dauer, wobei das Verhältnisband die Anteile von Luft- und Fluideinlass zur Spanneinrichtung während der vorher definierten Dauer ermittelt und wobei das Verhältnisband in Antwort auf die Spanneinrichtungstemperaturmessungen berechnet wird.

**13.** Verfahren nach Anspruch 11, ferner umfassend ein Einstellen von Luft- und Fluidanteilen in einem ersten Steuerungsbereich der Mehrzahl von Steuerungsbereichen, wenn eine erste Temperatur im ersten Steuerungsbereich liegt, wobei, wenn die erste Temperatur zu einer zweiten Temperatur in einem zweiten Steuerungsbereich übergegangen ist, Luft- und Fluidanteilen im zweiten Steuerungsbereich eingestellt werden.

**14.** Verfahren nach Anspruch 13

a) bei dem der erste Steuerungsbereich und der zweite Steuerungsbereich die gleichen sind, oder
b) bei dem der erste Steuerungsbereich und der zweite Steuerungsbereich verschiedene Steuerungsbereiche in der Mehrzahl von Steuerungsbereichen sind, oder
c) ferner umfassend das Bereitstellen eines angenäherten Temperaturbereichs als Totzonenbereich im zweiten Steuerungsbereich für die zweite Temperatur, und Steuern des Totzonenbereichs, um einen Einbruch während des Übergangs von der ersten Temperatur zur zweiten Temperatur zu verringern, insbesondere wobei das Verfahren ferner umfasst ein Verringern des Einbruchs durch Abwechseln der Luft und des Fluids in Anteilen, oder wobei das Verfahren ferner umfasst ein Verringern des Einbruchs durch Abschalten eines Einlasses für Luft und eines Einlassen für Fluid.

## Revendications

**1.** Système de régulation de température pour un mandrin (10), **caractérisé en ce qu'**il comprend ;

un premier orifice d'admission pour recevoir de l'air provenant d'une source d'air ;
un second orifice d'admission (24) pour recevoir un fluide provenant d'une source de fluide (40) ; et
au moins un orifice de sortie (21) pour transférer alternativement l'air et le fluide vers le mandrin pour réguler une température de surface du mandrin, l'air transféré à travers l'au moins un orifice de sortie ayant une première proportion de temps d'un laps de temps prédéterminé, et le fluide transféré à travers de l'au moins un orifice de sortie ayant une seconde proportion de temps du laps de temps prédéterminé.

**2.** Système de régulation de température selon la revendication 1, dans lequel

a) le fluide est à régulation de température, ou
b) le fluide comprend de l'eau, ou
c) le mandrin est un mandrin thermique de 200 mm ou de 300 mm.

**3.** Système de régulation de température selon la revendication 1 ou 2, comprenant en outre :

un premier système de régulation de température (342) pour réguler une augmentation de la température de surface ; et
un second système de régulation de température (20) pour réguler une réduction de la température de surface en alternant l'air et le fluide dans les première et seconde proportions de temps pendant le laps de temps prédéterminé, le second système de régulation de température comprenant des procédés de basse température et des procédés de régulateur pour gérer les transitions de température parmi une pluralité de plages de régulation.

**4.** Système selon la revendication 3, comprenant en outre une boîte de commande de valves (20) et un régulateur à action proportionnelle (343).

**5.** Système selon la revendication 4, dans lequel

a) la boîte de commande de valves comprend un clapet d'air (203) pour fournir l'air et une valve à fluide (205) pour fournir le fluide à régulation de température, spécialement dans lequel la valve à fluide est au moins une parmi une électrovalve haut débit et une électrovalve bas débit, ou dans lequel le clapet d'air et la valve à fluide fournissent l'air et le fluide selon un mode alternatif en réaction au régulateur, ou
b) la boîte de commande de valves comprend en outre un clapet d'air de base (208) pour fournir un refroidissement de base, ou
c) le régulateur à action proportionnelle comprend :

une interface (341) pour recevoir des informations de température mesurée provenant du mandrin thermique ;
un processeur de plage de régulation (302) pour définir la pluralité de plages de régulation et une pluralité de plages de basse température ;
un procédé de régulateur dans chaque plage de régulation ; et
un procédé de basse température dans chaque plage de basse température, spécialement quand le processeur de plage de régulation définit chaque plage de régulation et chaque plage de basse température par des limites de température.

**6.** Système selon la revendication 3, dans lequel quand une première température est dans une première plage de régulation de la pluralité de plages de régulation, un premier procédé de régulateur de la première plage de régulation ajuste les proportions d'air et de fluide, et dans lequel quand la première température est amenée à une deuxième température dans une deuxième plage de régulation, un deuxième procédé de régulateur de la deuxième plage de régulation ajuste les proportions d'air et de fluide.

**7.** Système pour mandrin thermique selon la revendication 6, dans lequel

a) la première plage de régulation et la deuxième plage de régulation sont les mêmes, ou
b) la première plage de régulation et la deuxième plage de régulation sont des plages de régulation différentes parmi la pluralité de plages de régulation, ou
c) une plage d'insensibilité dans la deuxième plage de régulation fournit une plage de températures approximative de la deuxième température, et dans lequel le deuxième procédé de régulateur régule la plage d'insensibilité pour réduire un sous-dépassement pendant la transition de la première température à la deuxième température, spécialement quand le deuxième procédé de régulateur réduit le sous-dépassement en alternant la première admission d'air et la seconde admission de fluide de manière proportionnelle, ou dans lequel le deuxième procédé de régulateur réduit le sous-dépassement en désactivant la première admission d'air et la seconde admission de fluide.

**8.** Système selon la revendication 3,

a) comprenant en outre des capteurs de température pour fournir des mesures de température de mandrin au système pour mandrin thermique, ou
b) dans lequel chaque procédé de régulateur comprend un dispositif d'ordonnancement du gain qui calcule une bande de proportion pendant le laps de temps prédéterminé, dans lequel la bande de proportion détermine les proportions des admissions d'air et de fluide vers le mandrin pendant le laps de temps prédéterminé, et dans lequel la bande de proportion est calculée en réaction aux mesures de température du mandrin.

**9.** Procédé de régulation d'une température de mandrin, **caractérisée par** les étapes :

recevoir de l'air depuis une source d'air ;
recevoir du fluide depuis une source de fluide (40) ; et

transférer alternativement l'air et le fluide vers le mandrin (10), l'air transféré à travers au moins un orifice de sortie ayant une première proportion de temps d'un laps de temps prédéterminé, et le fluide transféré à travers l'au moins un orifice de sortie ayant une seconde proportion de temps du laps de temps prédéterminé.

**10.** Procédé selon la revendication 9, comprenant en outre l'étape consistant à réguler une température du fluide.

**11.** Procédé selon la revendication 9 ou 10, incluant en outre les étapes :

réguler une augmentation d'une température de surface du mandrin ; et
réguler une réduction de la température de surface en alternant l'air et le fluide dans la première et la seconde proportion de temps pendant le laps de temps prédéterminé.

**12.** Procédé selon la revendication 11,

a) comprenant en outre l'étape consistant à gérer les transitions de température parmi une pluralité de plages de régulation, ou
b) dans lequel l'air et le fluide sont fournis selon un mode alternatif en réaction à un régulateur à action proportionnelle, spécialement dans laquelle le procédé comprend en outre l'étape consistant à recevoir des informations de température mesurée provenant du mandrin, ou
c) dans lequel chaque plage de régulation et chaque plage de basse température sont définies par des limites de température, ou
d) comprenant en outre l'étape consistant à calculer une bande de proportion pendant le laps de temps prédéterminé, dans laquelle la bande de proportion détermine les proportions d'admission d'air et de fluide vers le mandrin pendant le laps de temps prédéterminé, et dans laquelle la bande de proportion est calculée en réaction aux mesures de température du mandrin.

**13.** Procédé selon la revendication 11, comprenant en outre l'étape consistant à ajuster les proportions d'air et de fluide dans une première plage de régulation de la pluralité de plages de régulation quand une première température est dans la première plage de régulation, dans laquelle quand la première température est passée à une deuxième température dans une deuxième plage de régulation, ladite procédé comprend l'étape consistant à ajuster les proportions d'air et de fluide dans la deuxième plage de régulation.

**14.** Procédé selon la revendication 13,

a) dans lequel la première plage de régulation et la seconde plage de régulation sont les mêmes, ou
b) dans lequel la première plage de régulation et la deuxième plage de régulation sont des plages de régulation différentes parmi la pluralité de plages de régulation, ou
c) comprenant en outre l'étape consistant à fournir une plage de températures approximative en tant que plage d'insensibilité dans la seconde plage de régulation pour la seconde température, et réguler la plage d'insensibilité pour réduire un sous-dépassement pendant la transition de la première température à la deuxième température, spécialement dans laquelle le procédé comprend en outre l'étape consistant à réduire le sous-dépassement en alternant proportionnellement l'air et le fluide, ou dans laquelle le procédé comprend en outre l'étape consistant à réduire le sous-dépassement en désactivant une admission d'air et une admission de fluide.

FIG. 1

EP 1 861 759 B1

FIG. 2

FROM
AIR
SOURCE

PRESSURE
REGULATOR

CHECK
VALVE

AIR
SOLENOID
VALVE

LOW FLOW
SOLENOID
VALVE

LOW FLOW
ORIFICE

AIR PRESENT
SWITCH

HIGH FLOW
SOLENOID
VALVE

SERIAL
COMMUNICATIONS
CONVERTER

BASE COOLING
SOLENOID
VALVE

CHECK
VALVE

HIGH FLOW
ORIFICE

TO CHUCK
BASE AIR

FLUID LEVEL
SWITCH

RS-485 TO/FROM
FLUID SOURCE (2-WIRE)

TO/FROM
CONTROLLER 30

TO/FROM
CHUCK 10

TO/FROM
FLUID SOURCE 40

AIR
FLUID
CONTROL
AIR AND/OR FLUID

EP 1 861 759 B1

25

FIG. 3

EP 1 861 759 B1

FIG. 4

FIG. 5

EP 1 861 759 B1

FIG. 6

29

**FIG. 7A**

**FIG. 7B**

FIG. 8

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 3710251 A, Hagge
- US 4056708 A, Soodak
- US 5205132 A, Fu
- US 6700099 B